# FASCICULE DE BREVET EUROPEEN

(11) **EP 0 621 963 B1**
(45) Date de publication et mention de la délivrance du brevet: **22.09.1999**
(21) Numéro de dépôt: 93904110.9
(22) Date de dépôt: 22.01.1993
(51) Int. Cl.: G03F 7/029, C08F 2/50

(54) **SYSTEME PHOTOSENSIBLE SOUS IRRADIATION VISIBLE ET ULTRA-VIOLETTE POUR COMPOSITIONS FILMOGENES PIGMENTEES PHOTORETICULAIRES**
UV- und VIS empfindliches System für die Verwendung in filmbildenden pigmentierten lichtvernetzbaren Zusammensetzungen
VISIBLE AND ULTRAVIOLET IRRADIATION PHOTOSENSITIVE SYSTEM FOR FILM-FORMING PIGMENTED PHOTO-CROSSLINKABLE COMPOSITIONS

(30) Priorité: 24.01.1992 FR 9200977
(43) Date de publication de la demande: 02.11.1994
(73) Titulaire: CELLIOSE, F-69492 Pierre-Bénite Cédex (FR)
(72) Inventeur: CATILAZ, Laurence, F-68100 Mulhouse (FR); FOUASSIER, Jean-Pierre, F-68790 Morschwiller-le-Bas (FR); NAVERGONI, Paul, F-69320 Feyzin (FR)
(74) Mandataire: Gaucherand, Michel
(86) Numéro de dépôt international: FR9300066
(87) Numéro de publication internationale: WO9315440

(56) Documents cités:
- EP-A- 0 272 215
- EP-A- 0 364 735
- EP-A- 0 422 686

## Description

### DOMAINE DE L'INVENTION

L'invention concerne un système photosensible sous irradiation visible et ultra-violette destiné à être introduit dans des compositions filmogènes pigmentées photoréticulables pour revêtements afin d'en provoquer la polymérisation en formant un film protecteur et/ou décoratif réticulé.

L'invention concerne également les compositions filmogènes pigmentées photoréticulables pour revêtements contenant le système photosensible sous irradiation visible et ultra-violette.

L'invention concerne enfin l'application nouvelle des compositions filmogènes pigmentées photoréticulables pour revêtements contenant le système photosensible sous irradiation visible et ultra-violette destinées à la protection et/ou la décoration des supports les recevant, lesdites compositions étant appliquées sous des épaisseurs telles ou à une concentration pigmentaire telle qu'une monocouche de ladite composition opacifie totalement le support revêtu.

### ARRIERE-PLAN DE L'INVENTION

Une composition filmogène pigmentée ou non, pour revêtements, encore dénommée peinture ou vernis, peut durcir par simple évaporation des solvants ou encore par l'évaporation des solvants et l'action simultanée de l'oxygène de l'air ou enfin par des réactions de polycondensation, de polyaddition ou de polymérisation ionique ou radicalaire de ses constituants en présence ou non de solvants. Cette action de durcissement se fait par un apport d'énergie calorifique ou autre.

Dans le cas d'une polymérisation radicalaire des constituants d'une composition non pigmentée, qui sont des monomères et/ou des prépolymères à fonctions éthyléniques, l'apport d'énergie se fait généralement par une irradiation dans le domaine de l'ultra-violet en présence d'un système photosensible et photoamorceur du type radicalaire introduit au sein de la composition, en l'absence duquel la polymérisation des composants du film protecteur ne pourrait se faire.

Sous l'influence d'une irradiation dans l'ultra-violet, le système photoamorceur précité produit des radicaux libres qui provoquent la transformation des monomères et/ou prépolymères éthyléniques en radicaux libres par ouverture de la double liaison (phase d'initiation). Puis l'interaction des radicaux libres ainsi formés sur les autres molécules conduit, par un processus de réaction en chaîne, à la réticulation de tous les composés insaturés (phase de propagation) jusqu'à ce que les derniers radicaux libres se recombinent entre eux pour achever la polymérisation (phase de terminaison).

Dans le cas des compositions filmogènes non pigmentées (telles que vernis transparents, colorés ou non), la polymérisation radicalaire, grâce à la présence d'un système photoamorceur, se produit d'une manière complète, tant à coeur qu'en surface du film, pour des épaisseurs courantes telles que par exemple 100 µm à 150 µm, sous l'action d'une irradiation dans le domaine de l'ultra-violet et/ou du visible selon la sensibilité du système utilisé (C.G. ROFFEY : "Photopolymerization of Surface Coatings", Wiley, New-York, 1982 ; J.F. RABEK "Mechanisms of Photophysical and Photochemical Reactions in Polymer Chemistry. Theory and Practical Applications", Wiley, New-York, 1987 ; R. HOLMAN & P. OLDRING "UV & EB Curing Formulation for Printing Inks Coatings & Paints", SITA, London, 1988 ; S.P. PAPPAS, "UV Curing : Science and Technology, Technology Marketing Corporation", Stamford, CT, 1978).

Par contre, lorsque l'on tente d'introduire des pigments minéraux et/ou organiques dans des compositions filmogènes en présence d'un système photoamorceur identique ou équivalent à ceux précités, la polymérisation radicalaire ne peut plus s'effectuer correctement au sein du film déposé en raison de l'absorption par les pigments de l'irradiation photonique. Dès lors, pour que les compositions pigmentées polymérisent, l'épaisseur utile du film ne peut dépasser environ 25 µm, ce qui est très nettement insuffisant pour opacifier le support. Pour aboutir à l'opacification souhaitée, il est donc nécessaire de superposer plusieurs couches de faible épaisseur, chacune devant être irradiée avant le dépôt de la suivante (B.L BRANN, S.V. APPEL, "Radtech'88", North America, 1988, p. 508 - 511).

L'une des applications connues des compositions filmogènes fortement pigmentées polymérisant sous irradiation ultra-violette, est par exemple celle des encres d'imprimerie pour lesquelles le revêtement est déposé en très faible épaisseur (quelques microns) ce qui permet au système photoamorceur incorporé au sein de la composition de recevoir le flux irradiant suffisant pour effectuer la polymérisation à coeur (G. BERNER, G. RIST, W. RUTSCH, R. KIRCHMAYER : "Proc. Radcure Basel", Technical Paper, FC 85-446, 1985 ; L. MISEV : "Proc. Conf. on Radiation Curing Asia", Osaka, Japan, 1990, 404 et L. MISEV : "Conf. Proc. Radtech Europe 89", Florence, 359).

Toutefois l'homme de l'art a tenté de trouver des solutions aux inconvénients précités en réalisant des compositions pigmentées permettant leur application selon des épaisseurs de film plus importantes que dans le cas des encres.

L'une des solutions, encore exploitée aujourd'hui, consiste à mettre en oeuvre des compositions pigmentées contenant pour une partie, au moins un ou plusieurs monomères et/ou prépolymères à fonctions éthyléniques en présence d'un système photoamorceur de type radicalaire pour polymérisation sous irradiation ultra-violette, et pour l'autre partie, au moins un polymère à réticulation ionique sous une action thermique. Cette combinaison de deux mécanismes réactionnels différents permet de compenser la perte d'énergie photonique due à l'absorption pigmentaire d'une fraction importante de l'irradiation ultra-violette, par apport d'énergie thermique permettant la réticulation des polymères à réaction ionique (A. NOOMEN : "J.Oil. Col. Chem. Assoc.", 1981, 64 347-354 et S. PEETERS "Polym. Paint Colour J", 1989, 179, 304).

De même, la demande de brevet européen n°401 166 propose de préparer des compositions photopolymérisables sous irradiation ultra-violette ou visible, à partir d'un composé ayant une double liaison éthylénique polymérisable, d'un titanocène comme photoamorceur et éventuellement d'autres photoamorceurs du type benzophénone. De telles compositions présentent cependant l'inconvénient majeur de nécessiter une irradiation intense pour polymériser et d'être peu réactives lorsqu'elles contiennent des pigments.

Une autre solution développée plus récemment dans le monde de la peinture permet de polymériser, sous une irradiation ultra-violette, des compositions pigmentées à mécanisme de réticulation complètement radicalaire en utilisant un système photosensible composé de triphénylphosphine oxyde (TPO de la société BASF) décrit dans les brevets DE 2830927 et DE 2909994, pour la polymérisation à coeur, et d'un photoamorceur radicalaire classique (tel que par exemple le DAROCURE 1173 de la société MERCK) pour la polymérisation en surface. Un tel système est basé sur la capacité de la TPO à absorber une partie du spectre d'irradiation non capté en intégralité par les pigments, pour produire des radicaux libres susceptibles d'initier la réaction de polymérisation. Mais ces compositions, selon la nature du pigment ou encore selon son spectre d'absorption, ne permettent pas, en dehors des pigments blancs, de réaliser des films d'épaisseur suffisante pour l'opacification souhaitée (KLUG et KEIL - Congrès de l'AFTPV - Novembre 88).

Enfin, il a été récemment décrit (EP 0402932) un système permettant de polymériser des compositions filmogènes fortement pigmentées, appliquées sous des épaisseurs de 120 µm, lesdites compositions étant constituées d'un mélange de polymères ou prépolymères comportant généralement un polyester insaturé dans lequel on associe des sels organiques de métaux avec des photoamorceurs radicalaires connus, tels que par exemple la triphénylphosphine oxyde. Mais de tels systèmes nécessitent, pour une polymérisation complète de films pigmentés de 120µm d'épaisseur, la succession d'étapes de séchage à l'air ambiant ou à l'air chaud, puis de pré-irradiation dans le domaine de l'infra-rouge ou de l'ultra-violet de basse pression ou du proche ultra-violet et visible, et enfin d'irradiation ultra-violette de moyenne ou haute pression, totalisant un temps de polymérisation variant entre 5 minutes et 15 minutes. De tels temps de séchage sont beaucoup trop importants pour une utilisation industrielle qui nécessite des vitesses de polymérisation sous ultra-violets de l'ordre de 10 m/mn à 12 m/mn que l'on atteint pour des compositions incolores ou très faiblement pigmentées, ou fortement pigmentées mais appliquées sous de faibles épaisseurs ne dépassant pas 20 µm à 30 µm.

Par ailleurs, il existe des systèmes photosensibles susceptibles de provoquer la polymérisation de compositions filmogènes ou autres, sous irradiation ultra-violette et/ou visible, que la littérature spécialisée a largement décrits.

Un premier système connu consiste à associer un colorant photoréductible à une amine (telle que par exemple la tribenzylamine) et à un photoamorceur radicalaire (tel que par exemple le QUANTACURE PDO de la société WARD BLENKINSOP) dans des compositions à réticulation de type radicalaire sous irradiation ultra-violette telles que celles formulées par exemple à partir de polyesters insaturés (JP-KOKAI 80.94919). Dans le même esprit que ce premier système, il a été également décrit un système photosensible composé d'un agent donneur d'électrons (tel que par exemple un composé aminé) et d'un colorant photoréductible, dans des compositions photoréticulables sous une irradiation dans le domaine du visible, telles que celles formulées à partir de monomères vinyliques ou éthyléniques (US 3649495, US 2850445 et US 2875047).
Mais, les deux systèmes précités ne permettent pas de polymériser des compositions filmogènes photoréticulables sous l'action d'une irradiation dans le domaine de l'ultra-violet et/ou du visible lorsque l'on introduit dans celles-ci des pigments et que l'on souhaite obtenir un revêtement opacifiant.

Un autre des systèmes connus consiste en l'utilisation d'un composé organo-métallique (tel que par exemple, l'IRGACURE 261 de la société CIBA GEIGY) dans des compositions à réticulation de type cationique sous irradiation (EP 094915). Mais ce système ne fonctionne pas dans des compositions à réticulation de type radicalaire.

Un système appartenant également à l'art connu consiste en la combinaison d'un composé organo-métallique (tel que par exemple l'IRGACURE 261 de la société CIBA GEIGY) et d'un péroxyde ou d'un hydropéroxyde (tel que par exemple l'hydropéroxyde de cumène) dans des compositions à réticulation sous irradiation de type cationique et/ou radicalaire (EP 126712 et WO 8802879).
Mais un tel système ne permet pas de polymériser des compositions filmogènes pigmentées appliquées selon des épaisseurs importantes et suffisantes pour opacifier le support.

Un autre système connu consiste à associer un composé organo-métallique (tel que par exemple l'IRGACURE 261 de la société CIBA GEIGY) à un hydropéroxyde et à un agent sensibilisateur qui est un composé aromatique polycyclique (mais qui n'est pas un colorant) dans une composition photoréticulable de type cationique ou radicalaire (EP 0152377). Un tel système ne fonctionne pas dans les compositions photoréticulables pigmentées car l'agent sensibilisateur précité n'est sensible qu'aux irradiations ultra-violettes qui sont presque totalement absorbées par les pigments.

Enfin, un dernier système proposé dans la demande de brevet européen n°421 512 consiste à combiner un photocatalyseur, qui est un dérivé organo-métallique d'un élément de transition, avec un photoamorceur tel que la benzophénone, le diphényle ou leurs dérivés. Un tel système présente l'inconvénient majeur d'être très peu sensible sous irradiation visible ou ultraviolette, et de n'être applicable efficacement que lorsque les monomères en présence sont des monomères très réactifs comme le styrène et ses dérivés.

Ainsi, il apparaît qu'il existe bien un problème lié aux grandes difficultés à mettre en oeuvre des compositions filmogènes pigmentées photoréticulables puisqu'on ne parvient pas à polymériser ces compositions sous irradiation ultra-violette et/ou visible lorsqu'elles sont appliquées en épaisseur telle ou avec une concentration pigmentaire telle qu'elles sont opacifiantes.

Dès lors, un premier objet visé par l'invention consiste à créer un système photosensible permettant, après son introduction dans une composition filmogène pigmentée photoréticulable, de provoquer une polymérisation radicalaire de ladite composition sous irradiation dans le domaine du visible et de l'ultra-violet, même en présence des pigments.

Un deuxième objet visé par l'invention consiste à créer un système photosensible permettant, après son introduction dans une composition filmogène pigmentée photoréticulable, de provoquer une polymérisation radicalaire de ladite composition sous irradiation dans le domaine du visible et de l'ultra-violet, cette composition étant appliquée sous des épaisseurs telles ou avec une concentration pigmentaire telle, qu'une monocouche déposée opacifie complètement le support revêtu.

### SOMMAIRE DE L'INVENTION

Consciente des inconvénients précités, la demanderesse à travers ses recherches, a réalisé un système photosensible sous irradiation visible et ultra-violette pour des compositions filmogènes pigmentées photoréticulables destinées à des revêtements répondant aux objectifs qu'elle s'est imposés.

Le système photosensible sous irradiation visible et ultra-violette selon l'invention se caractérise en ce qu'il comporte :
a) au moins un complexe organo-métallique répondant à la formule :

   [R¹(R²M)ₙ][LQₘ]

   dans laquelle :
   - R¹ est une structure de type π-arène
   - R² est une structure de type π-arène ou est l'anion d'un π-arène
   - M est le cation d'un métal de valence 1 à 3 des groupes I B, IV B à VII B ou VIII de la classification périodique des éléments,
   - L est un métal ou non-métal de valence 2 à 7,
   - Q est un halogène
   - n est égal à 1 ou 2
   - m est un entier compris entre 3 et 8.
b) au moins un agent stabilisateur qui est un colorant ayant la propriété d'absorber, au moins pour partie, un domaine de longueur d'onde du spectre d'émission d'une ou plusieurs sources photoniques,
c) au moins un agent oxydant du type composé péroxy,
d) au moins un agent photoamorceur de réaction radicalaire,
e) éventuellement, au moins un agent donneur d'électrons.

### DESCRIPTION DETAILLEE DE L'INVENTION

Alors que l'art antérieur préconise des systèmes photosensibles sous irradiation ultra-violette, qui, une fois introduits dans des compositions de revêtement filmogènes suffisamment pigmentées pour opacifier les supports revêtus, conduisent à une polymérisation toujours incomplète en raison de l'absorption de l'irradiation ultra-violette par les pigments, le système selon l'invention s'en distingue par le fait qu'il crée une véritable synergie entre le complexe organo-métallique choisi et l'agent sensibilisateur en présence de l'agent oxydant, sous une irradiation dans le domaine du visible et de l'ultra-violet.

Selon l'invention, l'agent sensibilisateur ayant la propriété d'absorber, au moins pour partie, un domaine de longueur d'onde du spectre d'émission d'une ou de plusieurs sources photoniques dans le domaine du visible et éventuellement de l'ultra-violet, est un colorant organique. Ce colorant, qui atteint un état photoactivé ou excité sous l'action de l'irradiation, transfère son activation au complexe organo-métallique choisi, qui, à son tour et en présence de l'agent oxydant, va provoquer la création de radicaux libres à partir des liaisons éthyléniques présentes. La polymérisation radicalaire de la composition contenant le système se produit alors par ouverture des liaisons éthyléniques.
Un tel colorant peut être choisi dans le groupe constitué par les colorants nitrosés, nitrés, azos (mono, di, tri ou poly azos), azoïques, stilbéniques, les colorants de cétonimine, d'azométhine, de quinoline, de cyanine, de polyméthine, les colorants de triphénylméthane, de diphénylnaphtylméthane, les colorants xanthéniques, les colorants d'acridine, de thiazole, d'indamine, d'indophénol, les colorants aziniques, oxaziniques, thiaziniques, les colorants au soufre, les colorants d'hydroxycétone, les colorants dérivés des quinones et anthraquinones, les colorants indigoides et thioindigoïdes, les colorants de phtalocyanine.
Préférentiellement, le colorant (agent sensibilisateur) intervenant dans le système selon l'invention est choisi parmi ceux présentant la formule suivante : 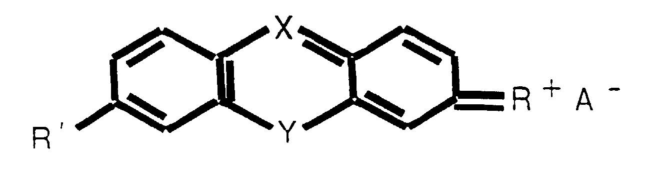 où
R est chargé positivement et est un groupe imonium, dialkylimonium ou oxonium ;
R' est un hydrogène ou un groupe amine, alkylamine, dialkylamine ou hydroxyle ;
X est l'azote ou un carbone substitué ;
Y est le soufre, l'oxygène ou l'azote substituée ;
et A est un anion.

Il est clair que les doubles liaisons et la charge positive sur R peuvent se réarranger dans des formes mésomères ou configurations plus stables, sans affecter en aucune façon la validité de la représentation par la formule ci-dessus.
Très préférentiellement le colorant peut être choisi dans le cadre de l'invention parmi ceux possédant la structure ci-dessus, tels que par exemple, l'éosine Y, le rose de Bengale, l'azure B, la phénosafranine, l'érythrosine B, la phloxine, la riboflavine, la fluoresceïne, la rhodamine B, la safranine O, la pyronine B, le bleu de méthylène, la thionine, le bleu de Capri, l'azure A, le jaune d'acridine, l'orange d'acridine ou la résorufine. D'autres colorants ne possédant pas la structure décrite ci-dessus peuvent être également choisis très préférentiellement dans le système photosensible selon l'invention, comme par exemple la thioflavine T.

Selon l'invention, le complexe organo-métallique choisi est du type de ceux décrits et revendiqués dans le brevet EP 094915 en tant que photoamorceurs dans des compositions polymérisables cationiques. Un tel complexe organo-métallique est représenté par la formule générale suivante :

[R¹(R²M)ₙ][L Qₘ]

où
- R¹ est une structure de type π-arène
- R² est une structure de type π-arène ou est l'anion d'un π-arène
- M est le cation d'un métal de valence 1 à 3, des groupes I B, IV B à VII B ou VIII de la classification périodique des éléments,
- L est un métal ou non-métal de valence 2 à 7,
- Q est un halogène,
- n est égal à 1 ou 2,
- m est un entier compris entre 3 et 8.

Préférentiellement, le complexe π-arène métal selon l'invention est choisi parmi les sels complexes d'un cation η⁶, η⁵ arène fer et d'un anion non-nucléophile, dont la formule générale est la suivante : 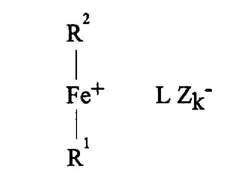 où
- R¹ est un η⁶ arène tel que du benzène, un alkylbenzène comme par exemple le toluène, le xylène, le mésitylène, le cumène; un alkoxybenzène; le chlorobenzène; un haloalkylbenzène, comme par exemple le p-chlorotoluène; le naphtalène; un alkoxynaphtalène, comme par exemple le méthoxynaphtalène; un alkylnaphtalène, comme par exemple le méthylnaphtalène; un halonaphtalène comme par exemple, le chloronaphtalène; un biphényle; l'indène; le pyrène; ou le diphénylsulfide,
- R² est l'anion d'un composé cyclopentadiénique tel que par exemple le cyclopentadiène, l'acétylcyclopentadiène, le benzoylcyclopentadiène, le butylcyclopentadiène, l'amylcyclopentadiène, l'indène,
- L est un métal ou métalloïde de valence 2 à 7,
- Z est un halogène,
- k est égal à la valence de L + 1.
De tels ions LZₖ⁻ sont par exemple SbF₆⁻, BF₄⁻, AsF₆⁻, PF₆⁻.

De tels complexes π-arène métal selon l'invention ont par exemple les formules suivantes :

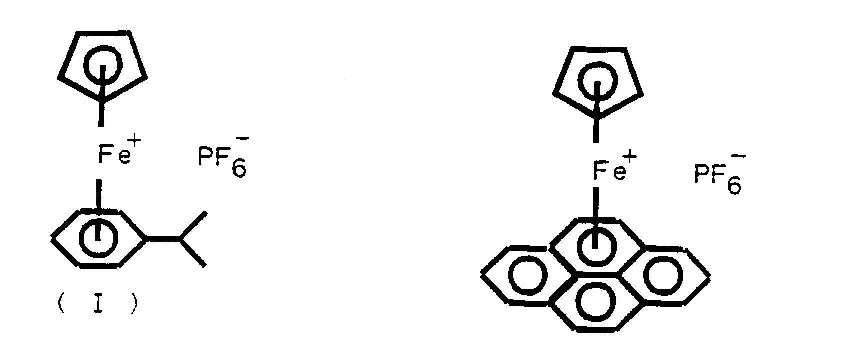

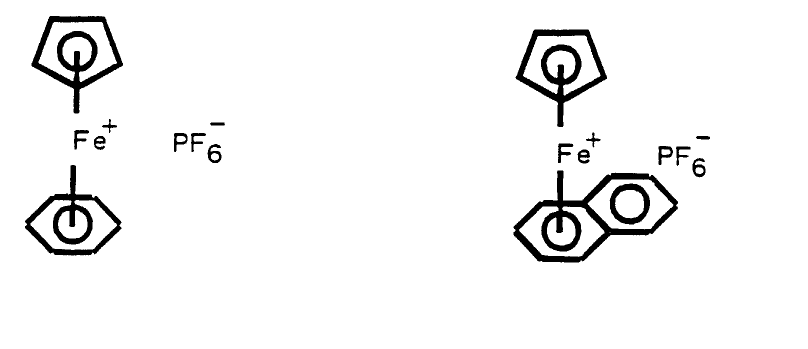

Le complexe π-arène métal selon l'invention est par exemple, comme représenté par la formule I, le (η⁵-2,4-cyclopentadièn-1-yl) [(1, 2, 3, 4, 5, 6- η) -(1-méthyléthyl)benzène] - fer (1+) hexafluorophosphate (1-) commercialisé sous la référence IRGACURE 261 par la société CIBA-GEIGY.

L'agent oxydant du type composé péroxy faisant partie du système photosensible selon l'invention est un composé contenant au moins une liaison O-O. Il peut être choisi parmi les peroxydes ou les hydropéroxydes organiques, les peresters, ou leurs dérivés, tels que par exemple l'hydropéroxyde de tertiobutyle, l'hydropéroxyde de cumène, l'hydropéroxyde de triphénylméthyle, l'hydropéroxyde de tétraline, l'hydropéroxyde de méthyltétraline, l'hydropéroxyde de décaline, le perbenzoate de butyle tertiaire, l'éthyl-2-perhexanoate de butyle tertiaire, ou autres.

L'agent photoamorceur de type radicalaire, contenu dans le système photosensible selon l'invention, est choisi parmi les composés connus capables d'absorber une irradiation dans le domaine de l'ultra-violet, pour produire des radicaux libres susceptibles d'initier la réaction de polymérisation radicalaire.
De tels composés sont choisis dans le groupe constitué par les dérivés des cétones aromatiques telles que par exemple la benzophénone ou l'isopropylthioxanthone commercialisée par exemple par la société WARD BLENKISOP sous l'appellation QUANTACURE ITX, les dérivés de l'acétophénone tels que par exemple l'hydroxycyclohexylacétophénone commercialisée par la société CIBA GEIGY sous l'appellation IRGACURE 184 ou la diméthylhydroxyacétophénone commercialisée par la société MERCK sous l'appellation DAROCURE 1173, les dérivés de la benzoïne, les dérivés des benzylcétals tels que par exemple la 2,2 diméthoxy 1,2 diphényléthane 1-one commercialisée par la société CIBA GEIGY sous l'appellation IRGACURE 651, les morpholinocétones telles que par exemple la 2-méthyl-1-[4-(méthylthio)phényl] -2-morpholinopropanone-1 commercialisée par la société CIBA GEIGY sous l'appellation IRGACURE 907, les dérivés sulfoxydiques de cétones aromatiques, les dérivés de type sulfonyl cétones, les oxydes d'acylphosphines tels que par exemple l'oxyde de triméthyl-2, 4, 6 benzoyldiphénylphosphine commercialisé par la société BASF sous l'appellation LUCIRINE TPO), les dérivés de type phénantrènequinone, les titanocènes, en particulier ceux comportant des cycles aromatiques substitués par un ou plusieurs halogènes et éventuellement un ou plusieurs autres substituants améliorant leur solubilité.

L'agent donneur d'électrons du système photosensible selon l'invention peut être choisi parmi les composés azotés, soufrés ou phosphorés donneurs d'électrons.
Selon un premier type de composés, les donneurs d'électrons azotés sont de formule générale R₃N dans laquelle au moins l'un des trois radicaux R est un radical organique relié à l'atome d'azote, tel que par exemple -CH₂R', -CH R'₂ ou CR'₃ où R' est un atome d'hydrogène ou un hydrocarbure ou un hydrocarbure substitué, et les deux autres radicaux R peuvent être l'hydrogène.
Préférentiellement, l'agent donneur d'électrons azoté est choisi parmi les composés de type amine secondaire, tels que par exemple la N-phénylglycine ou la dibenzylamine, les composés de type amine tertiaire aliphatiques tels que par exemple la N-méthyldiéthanolamine ou la triéthylamine ou la triéthanolamine, les composés de type amine tertiaire aromatiques tels que par exemple la triphénylamine ou l'éthyl-4-(diméthylamino)benzoate commercialisé sous l'appellation QUANTACURE EPD par la société WARD BLENKINSOP, ou le 2-(diméhtylamino)-éthylbenzoate commercialisé sous l'appellation QUANTACURE DMB par la société WARD BLENKINSOP.

Selon un deuxième type de composés, les donneurs d'électrons soufrés constituent le groupe des mercaptans dont la formule générale est RSH, où R est un radical alkyl, arylalkyl ou aryl, dont font partie par exemple le mercaptobenzothiazole ou le mercaptobenzooxazole.

Selon un troisième type de composés, les donneurs d'électrons phosphorés sont choisis parmi les composés de type triphénylphosphine.

Selon l'invention, le système photosensible sous irradiation visible et ultra-violette est mis en oeuvre dans des compositions filmogènes pigmentées photoréticulables selon les quantités suivantes de chacun de ses constituants, exprimées pour 100 parties en poids desdites compositions :
a) de 0,00001 à 1,0 parties en poids, préférentiellement de 0,0001 à 0,1 parties en poids et très préférentiellement de 0,0001 à 0,01 parties en poids de l'agent sensibilisateur qui est le colorant.
b) de 0,005 à 5 parties en poids et préférentiellement de 0,05 à 3 parties en poids du complexe organo-métallique.
c) de 0,005 à 5 parties en poids et préférentiellement de 0,05 à 3 parties en poids de l'agent oxydant du type composé péroxy.
d) de 0,1 à 8 parties en poids et préférentiellement de 0,5 à 5 parties en poids de l'agent photoamorceur de réaction radicalaire.
e) de 0 à 10 parties en poids et préférentiellement de 0 à 5 parties en poids de l'agent donneur d'électrons.

Les compositions filmogènes pigmentées photoréticulables pour revêtements dans lesquelles on incorpore le système photosensible selon l'invention sont constituées d'au moins un polymère et/ou prépolymère à fonctions éthyléniques libres, au moins un monomère (encore appelé diluant réactif) à fonctions éthyléniques libres, éventuellement au moins un solvant organique, au moins un pigment pulvérulent insoluble, tinctoriel ou non, éventuellement au moins une matière de charge pulvérulente et éventuellement au moins un additif classiquement utilisé par l'homme de l'art dans les compositions de revêtements.

Le polymère et/ou prépolymère à fonctions éthyléniques libres, encore appelé oligomère, contenu dans les compositions filmogènes pigmentées selon l'invention, est choisi parmi tous les polymères et/ou prépolymères susceptibles de réticuler par voie radicalaire sous irradiation, tels que par exemple :
- les polymères et/ou prépolymères époxy-acrylates et/ou époxyméthacrylates obtenus par réaction du groupement époxyde d'un composé tel que par exemple le diglycidyléther de bisphénol A, une huile époxydée (telle que par exemple une huile de lin ou de soja époxydée), une époxy-novolaque ou d'autres composés époxydés, avec de l'acide acrylique et/ou méthacrylique. De tels polymères et/ou prépolymères sont connus sous des appellations commerciales telles que par exemple EBECRYL 1608 de la société UCB, CRAYNOR CN115 de la société CRAYNOR, LAROMER EA81 de la société BASF ou ACTILANE 70 de la société SNPE ;
- les polymères et/ou prépolymères uréthanne-acrylates et/ou uréthanneméthacrylates, aromatiques et/ou aliphatiques, obtenus par réaction du groupement isocyanate d'un composé tel que par exemple le toluène diisocyanate (TDI), l'hexaméthylène diisocyanate (HMDI) ou l'isophorone diisocyanate (IPDI), sur le groupement hydroxyle d'un monomère acrylique et/ou méthacrylique hydroxylé tel que par exemple l'hydroxyéthylalcrylate, l'hydroxypropylacrylate ou l'hydroxyéthylméthacrylate.
Une variante de cette réaction permet d'obtenir des molécules très souples telles que des polyesters uréthannes acrylates issus de la réaction d'un composé à longue chaîne de type polyester (ou polyéther) diol-alliphatique, avec un composé de type diisocyanate tel que ceux cités plus haut et avec un composé acrylique et/ou méthacrylique hydroxylé du type de ceux précités.
Une autre variante de cette réaction permet d'obtenir des molécules très réactives conduisant à un haut degré de réticulation, telles que celles obtenues par la réaction d'un composé tri-(ou poly)hydroxylé à chaîne courte, avec le composé de type diisocyanate et le composé acrylique et/ou méthacrylique du type de ceux cités plus haut.
De tels polymères et/ou prépolymères uréthanne-acrylates et/ou uréthanne-méthacrylates sont connus sous des appellations commerciales telles que par exemple EBECRYL 264 de la société UCB, SETACURE AP576 de la société AKZO, ACTILANE 2330H de la société SNPE ou CRAYNOR CN934D60 de la société CRAYNOR ;
- les polymères et/ou prépolymères polyesters acrylates et/ou polyesters méthacrylates qui sont obtenus par condensation d'acide acrylique et/ou méthacrylique sur les groupements hydroxyles résiduels libres d'un polyester saturé, ou par réaction d'un composé de type hydroxy-acrylate tel que par exemple un alcool primaire insaturé, sur les groupements carboxyliques résiduels libres d'un polyester saturé.
De tels polymères et/ou prépolymères constituant une famille très variée en fonction du type de polyester de base utilisé, sont connus sous des appellations commerciales telles que par exemple LAROMER PE55F de la société BASF, EBECRYL 850 de la société UCB, ou CRAYNOR CN220 de la société CRAYNOR ;
- les polymères et/ou prépolymères polyéther acrylates et/ou polyéther-méthacrylates obtenus par réaction de trans-estérification d'un monomère acrylique et/ou méthacrylique (tel que par exemple l'éthylacrylate) sur les groupements hydroxyles libres d'un polyéther polyhydroxylé. De tels polymères et/ou prépolymères sont connus sous des appellations commerciales telles que par exemple LAROMER LR8748 de la société BASF ou CRAYNOR CN435 de la société CRAYNOR ;
- les polymères et/ou prépolymères polyesters insaturés obtenus généralement par réaction entre un glycol tel que par exemple le 1,2 propylène-glycol, avec au moins 2 diacides, dont un acide insaturé tel que par exemple l'acide fumarique ou l'anhydride maléique. Ces polymères et/ou prépolymères qui sont généralement en solution dans le styrène, qui ont une réactivité plus lente que les polymères et/ou prépolymères acrylates et/ou méthacrylates et qui donnent des films en général moins souples que ces derniers, sont connus sous des appellations commerciales telles que, par exemple, SYNCRYL 1080 de la société GALSTAFF, LAROMER LR8532 de la société BASF ou EBECRYL 505 de la société UCB ;
- d'autres polymères et/ou prépolymères très divers peuvent être utilisés dans les compositions filmogènes pigmentées selon l'invention, tels que par exemple les polymères et/ou prépolymères de type vinyl-acryliques obtenus par copolymérisation de monomères très variés ou encore des composés de type polyène-thiols obtenus par exemple par copolymérisation entre des oléfines et des mercaptans.

Le monomère à fonction éthylénique libre contenu dans les compositions filmogènes pigmentées selon l'invention est choisi parmi les monomères vinyliques et/ou acryliques mono et/ou polyfonctionnels.
Un tel monomère peut être choisi dans le groupe constitué par les monomères vinyliques tels que par exemple le styrène, le vinyltoluène, l'acétate de vinyl, la N-vinyl pyrrolidone (NVP), les monomères acryliques monofonctionnels (tels que par exemple le 2-éthylhexylacrylate (2EHA), le n-hexylacrylate, le cyclohexylacrylate, le n-décylacrylate, l'isobornylacrylate, le dicyclopentenyl oxyéthylacrylate (commercialisé sous la référence QM672 par la société ROHM and HASS), le phénoxyléthylacrylate (commercialisé sous la référence EBERCRYL 110 par la société UCB), les monomères acryliques difonctionnels tels que par exemple le tripropylèneglycol diacrylate (TPGDA), le 1-6 hexanedioldiacrylate (HDDA), le dianoldiacrylate (marque déposée par la société AKZO CHEMIE), le tétraéthylèneglycoldiacrylate (TEGDA), le 1-4 butanedioldiacrylate (BDDA), le néopentylglycoldiacrylate (NPGDA), les monomères acryliques trifonctionnels tels que par exemple le triméthylolpropanetriacrylate (TMPTA), pentaérythritoltriacrylate (PETIA), les monomères acryliques multifonctionnels tels que par exemple le pentaérythritoltétraacrylate ainsi que tous monomères et/ou diluants réactifs de fonctionnalité variable qui ne sont pas des composés chimiquement définis et dont seule la famille est précisée par les producteurs, mais qui ont pour fonction d'abaisser la viscosité d'une composition filmogène photoréticulable, tout en réticulant lors de l'irradiation avec le ou les polymères et en participant par conséquent à la structure du film sec, tels que par exemple le SETACURE AM551 qui est un uréthanne aliphatique triacrylate ou le SETACURE AM559 qui est un acrylate alkoxylé modifié, tous deux commercialisés par la société AKZO CHEMIE ou encore l'EBECRYL 110 qui est un phénol acrylate oxyéthylé commercialisé par la société UCB.

Les solvants organiques éventuellement contenus dans la composition filmogène pigmentée selon l'invention, sont choisis parmi les solvants organiques volatils usuels du domaine des peintures et vernis et connus de l'homme de l'art, tels que par exemple les hydrocarbures aromatiques, les esters, les cétones, les alcools, les glycols, les esters et éthers de glycols ou encore les polyols.

Les pigments de la composition filmogène selon l'invention sont choisis parmi tous les pigments pour peintures usuellement utilisés par l'homme de l'art, tels que par exemple les pigments tinctoriels blancs minéraux, les pigments tinctoriels jaunes, verts, bleus, rouges, bruns, oranges, violets, noirs, qu'ils soient minéraux ou organiques, les poudres métalliques telles que par exemple aluminium, cuivre, bronze, zinc ou les pigments anticorrosion tels que par exemple chromate de zinc ou de strontium ou phosphates de zinc.

Les matières de charges sont choisies parmi tous les composés pulvérulents usuels du domaine des peintures et connus de l'homme de l'art, tels que par exemple carbonate de calcium, silicates, sulfate de baryum, silices naturelles, précipitées ou pyrogénées, sulfate de calcium, talcs, argiles, dolomites, gypses, micas, les fibres et microsphères de verre, creuses ou non, les charges organiques telles que par exemple fibres de KEVLAR, poudre de polyéthylène.

Les additifs sont choisis parmi tous les additifs usuels classiquement utilisés par l'homme de l'art dans les peintures pigmentées traditionnelles ou dans les vernis incolores polymérisant sous irradiation ultra-violette, tels que par exemple des agents mouillants, des agents d'étalement ou de tension qui peuvent être par exemple des silicones acrylates susceptibles de co-réticuler dans le film ou des additifs siliconés traditionnels qui ne réticulent pas, des agents anti-rayures, des agents dispersants pour pulvérulents, des agents absorbeurs U.V., des agents mattants, minéraux ou organiques.

L'invention sera mieux comprise grâce à la description de quelques exemples illustratifs de compositions filmogènes pigmentées polymérisant sous irradiation et comportant le système photosensible selon l'invention.

### EXEMPLES 1 A 3

Ces exemples ont pour but d'illustrer des compositions filmogènes pigmentées pour revêtements, polymérisant sous irradiation, dans 3 couleurs différentes, comportant le système photosensible selon l'invention, par rapport aux mêmes compositions filmogènes pigmentées, mais comportant un système photosensible appartenant à l'art antérieur.

### EXEMPLE 1

On prépare d'abord une pâte pigmentaire concentrée beige P1, par dispersion au défloculeur, puis broyage dans un broyeur à billes de verre, de plusieurs pigments dont le mélange donne la teinte beige désirée, dans un agent dispersant qui est l'acétobutyrate de cellulose auquel on ajoute un monomère acrylique qui est l'hexanedioldiacrylate (HDDA).
La composition de cette pâte pigmentaire beige P1 est, en poids, la suivante :
- Acétobutyrate de cellulose 10
   CAB 552.001 de la société EASTMAN KODAK
- HDDA de la société UCB 40,1
- Pigment jaune de chrome 3,25
   GU 25 de la société CIBA GEIGY
- Pigment rouge IRGALITHE RBS 0,04
   de la société CIBA GEIGY
- Pigment noir de carbone prédispersé en chips 0,033
   d'acétobutyrate de cellulose
   DISPERCAB CBLV de la société KVK
- Pigment blanc d'oxyde de titane rutile 46,55
   RL 60 de la société THANN ET MULHOUSE

On ajoute ensuite cette pâte pigmentaire P1 par mélange au défloculeur à un prépolymère et à un monomère acryliques, pour obtenir une composition filmogène pigmentée de couleur beige R1, susceptible de polymériser sous irradiation si on y ajoute un système photosensible.
La composition filmogène pigmentée R1 est, en poids, la suivante :
- Prépolymère époxyacrylate 50
   ACTILANE 70 de la société SNPE
- Monomère acrylique difonctionnel 30
   HDDA de la société UCB
- Pâte pigmentaire beige P1 20

On réalise ensuite, à partir de la composition R1, deux compositions réticulables sous irradiation C1 et C2, en y incorporant, par mélange au défloculeur, dans le cas de C1, le système photosensible selon l'invention et dans le cas de C2, un système photosensible appartenant à l'art antérieur.
La composition C1 est, en poids, la suivante :
- Composition pigmentée R1 100

### Système photosensible selon l'invention :

- DAROCURE 1173 de la société MERCK 2
- Methyldiéthanolamine (MDEA) 2
- IRGACURE 261 de la société CIBA GEIGY 0,1
- Hydroperoxyde de cumène 0,1
- Solution de rose de Bengale à 0,1 % dans l'éthanol 2

La composition C2 est, en poids, la suivante :
- Composition pigmentée R1 100

### Système photosensible selon l'art antérieur :

- LUCIRINE TPO de la société BASF 1
- DAROCURE 1173 de la société MERCK 3

On applique ensuite chacune des 2 compositions C1 et C2 sur des plaques de particules de bois mélaminées à l'aide d'un applicateur manuel à épaisseur contrôlée de type "Hand Coater" sous des épaisseurs croissantes et on essaye de réticuler chaque application par 3 passages à la vitesse de 10 m/mn sous une lampe U.V. à vapeur de mercure, de moyenne pression (80 watts/cm).
On note l'épaisseur maximale de revêtement polymérisée totalement (en surface et à coeur) dans ces conditions d'irradiation.

Les résultats sont résumés dans le tableau ci-après :

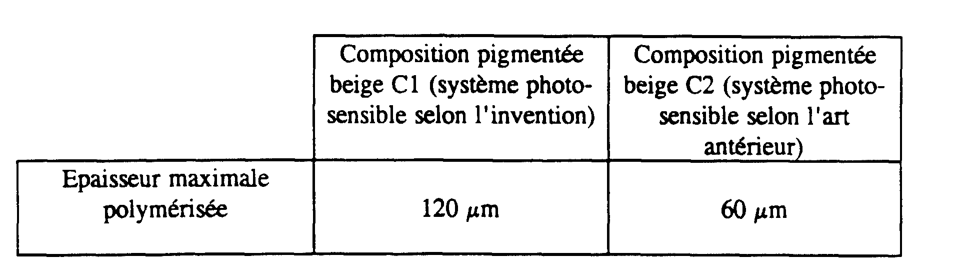

Ainsi il est constaté que le système photosensible selon l'invention permet de polymériser une épaisseur de revêtement pigmenté beige double de celle que permet un système photosensible selon l'art antérieur.

### EXEMPLE 2

On prépare une pâte pigmentaire concentrée jaune P2, suivant le même principe que dans l'Exemple 1, dont la composition est, en poids, la suivante :
- Acétobutyrate de cellulose 10
   CAB 552.001 de la société EASTMAN KODAK
- HDDA de la société UCB 40
- Pigment jaune de chrome 50
   GU 25 de la société CIBA GEIGY

On met ensuite en oeuvre cette pâte comme dans l'Exemple 1 pour obtenir une composition filmogène pigmentée R2, qui est, en poids :
- Prépolymère ACTILANE 70 de la société SNPE 50
- HDDA de la société UCB 10
- Pâte pigmentaire jaune P2 40

On réalise ensuite comme dans l'Exemple 1, deux compositions réticulables C3 et C4, en y incorporant, dans les mêmes proportions que dans l'Exemple 1, pour C3 le système photosensible selon l'invention de même composition que celui de l'Exemple 1 et pour C4 le système photosensible appartenant à l'art antérieur tel que décrit dans l'Exemple 1. Ces deux compositions C3 et C4 sont appliquées comme dans l'Exemple 1 sous des épaisseurs croissantes, puis à chaque fois irradiées dans les conditions de l'Exemple 1.
On note l'épaisseur maximale de revêtement polymérisée totalement dans ces conditions.

Les résultats sont résumés dans le tableau ci-après :

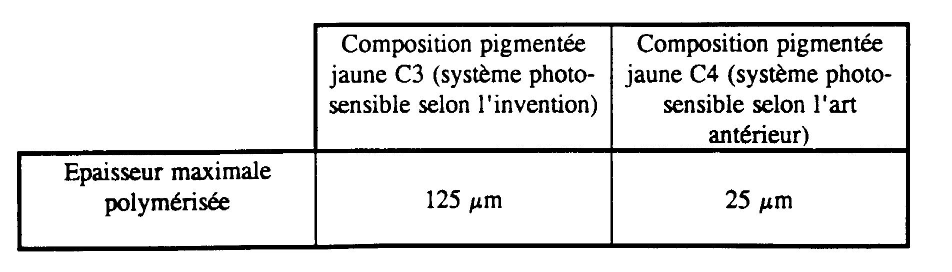

Ainsi, il est constaté que le système photosensible selon l'invention permet de polymériser une épaisseur de revêtement pigmenté jaune 5 fois plus grande que celle que permet un système photosensible selon l'art antérieur.
Il est observé que sous l'épaisseur maximale polymérisée avec le système photosensible selon l'art antérieur, le revêtement n'opacifie pas le support, alors que la composition contenant le système photosensible peut être polymérisée sous une épaisseur qui opacifie totalement le support.

### EXEMPLE 3

On prépare une composition filmogène pigmentée noire R3 par mélange au défloculeur d'un pigment noir prédispersé en chips avec un prépolymère et un monomère acryliques :
- Prépolymère ACTILANE 70 de la société SNPE 50
- HDDA de la société UCB 48,5
- Pigment noir de carbone prédispersé en chips 1,5
   DISPERCAB CBLV de la société KVK

On réalise ensuite, à partir de la composition R3, deux compositions réticulables sous irradiation C5 et C6, en y incorporant, pour C5 le système photosensible selon l'invention et dans le cas de C6, un système photosensible selon l'art antérieur, tel que décrit dans l'Exemple 1 et dans les mêmes proportions.

La composition C5 est, en poids, la suivante :
- Composition pigmentée R3 100

### Système photosensible selon l'invention :

- DAROCURE 1173 de la société MERCK 2
- Methyldiéthanolamine (MDEA) 1,5
- IRGACURE 261 de la société CIBA GEIGY 1
- Hydroperoxyde de cumène 1
- Solution de rose de Bengale à 0,1 % dans l'éthanol 2

La composition C6 est, en poids, la suivante :
- Composition pigmentée R3 100

### Système photosensible selon l'art antérieur :

- LUCIRINE TPO de la société BASF 1
- DAROCURE 1173 de la société MERCK 3

En appliquant, comme dans l'Exemple 1, ces deux compositions sous des épaisseurs croissantes et en irradiant à chaque fois ces applications dans les mêmes conditions que l'Exemple 1, on note l'épaisseur maximale de revêtement totalement polymérisée dans ces conditions.

Les résultats sont résumés dans le tableau ci-après :

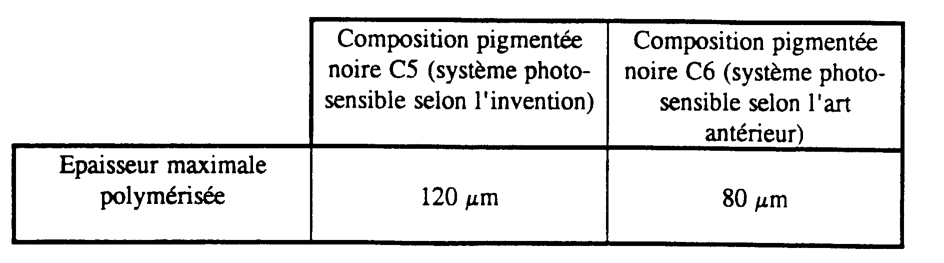

Ainsi, on constate que le système photosensible selon l'invention permet de polymériser une épaisseur de revêtement pigmenté noir qui est 1,5 fois celle autorisée par un système photosensible selon l'art antérieur, donc permettant une opacification du support très supérieure à l'art antérieur.

### EXEMPLE 4

Cet exemple a pour but de montrer l'importance et le rôle de chaque constituant du système photosensible selon l'invention.
A partir de la composition filmogène pigmentée beige R1 décrite dans l'Exemple 1, on réalise des compositions réticulables sous irradiation en y incorporant le système photosensible selon l'invention, en intégralité tout d'abord, puis en enlevant chacun de ses constituants séparément, tout en conservant les autres.
On réalise donc les compositions C7 à C11 décrites en poids dans le tableau ci-après :

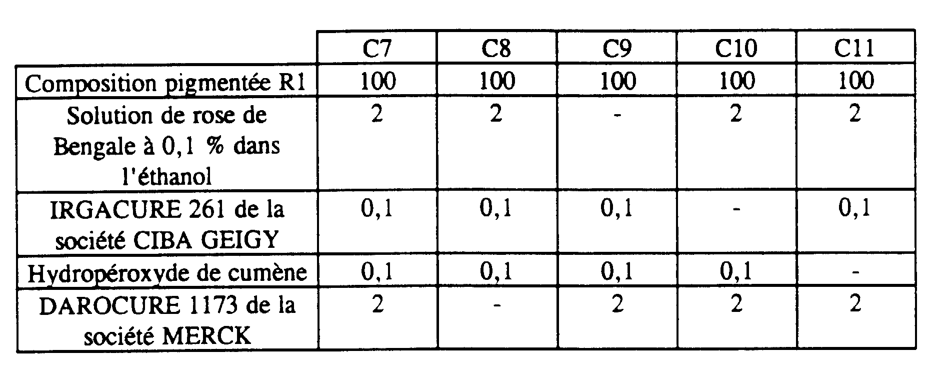

Comme dans l'Exemple 1, chacune des compositions est appliquée sur une plaque mélaminée au "Hand Coater" sous des épaisseurs croissantes que l'on essaye à chaque fois de réticuler par 3 passages à 10 m/mn sous une lampe à vapeur de mercure de 80 watts/cm.

On note l'épaisseur maximale de revêtement polymérisée et les résultats sont regroupés dans le tableau ci-après :

| Composition | C7 | C8 | C9 | C10 | C11 |
|---|---|---|---|---|---|
| Epaisseur maximale polymérisée | 120 µm | 120µm (mais la surface reste collante) | Quelques µm (<10 µm) Seule la surface est polymérisée | | |

Ainsi, il apparaît que chacun des constituants suivants, colorant, organo-métallique, hydropéroxyde, est indispensable pour permettre la polymérisation à coeur d'un revêtement pigmenté tel que celui décrit dans ces conditions d'irradiation.
Bien que le photoamorceur radicalaire DAROCURE 1173 n'apporte que la polymérisation en surface, il est également indispensable pour que la surface soit correctement réticulée.
Seul le mélange des quatre constituants du système selon l'invention permet donc la polymérisation complète de la composition pigmentée beige, sous une épaisseur de 120 µm qui opacifie totalement le support.

### EXEMPLE 5

Cet exemple a pour but de montrer le rôle que peut jouer l'agent donneur d'électrons dans le système photosensible selon l'invention.
Ce rôle est illustré par les 3 compositions pigmentées beiges réticulables sous irradiation, C12 à C14, décrites en poids dans le tableau ci-après :

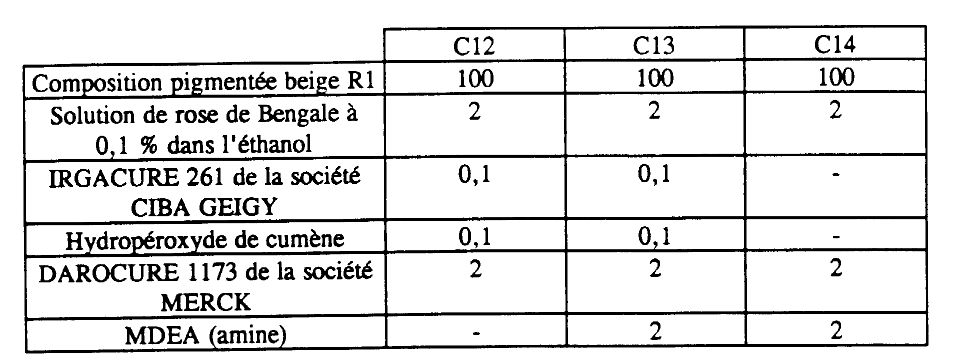

Comme dans les exemples précédents, chacune des compositions est appliquée sous des épaisseurs croissantes que l'on essaye, à chaque fois, de réticuler dans les mêmes conditions que précédemment.
L'épaisseur maximale de revêtement polymérisée est relevée et les résultats sont regroupés dans le tableau ci-après :

| Composition | C12 | C13 | C14 |
|---|---|---|---|
| Epaisseur maximale polymérisée | 120 µm (mais la teinte initiale est modifiée à cause de la présence de la forme colorée du colorant | 120 µm (la teinte n'est pas modifiée car la forme colorée du colorant disparaît) | aucune polymérisation à coeur, légère polymérisation en surface |

Ainsi, il est montré que pour les concentrations décrites ici dans les autres constituants du système selon l'invention, le donneur d'électrons (MDEA) n'apporte qu'une décoloration du colorant sensibilisateur, ce qui restitue la teinte initiale beige de la composition filmogène pigmentée R1. Mais il n'est pas observé d'augmentation de l'épaisseur polymérisée du fait de la présence de l'amine.
Par contre, il apparaît qu'un système photosensibilisateur ne comportant qu'un colorant et un donneur d'électrons ainsi qu'un photoamorceur radicalaire comme il est décrit dans l'art antérieur ne peut pas polymériser un revêtement pigmenté tel que celui décrit, dans les conditions de polymérisation définies ici.

### EXEMPLE 6

Cet exemple a pour but de montrer le rôle joué par les différents constituants du système photosensible selon l'invention avec des concentrations plus élevées en organo-métallique et en agent oxydant.
A partir de la composition filmogène pigmentée beige R1 décrite dans l'Exemple 1, on réalise cinq compositions réticulables sous irradiation, C15 à C19, décrites en poids dans le tableau ci-après :

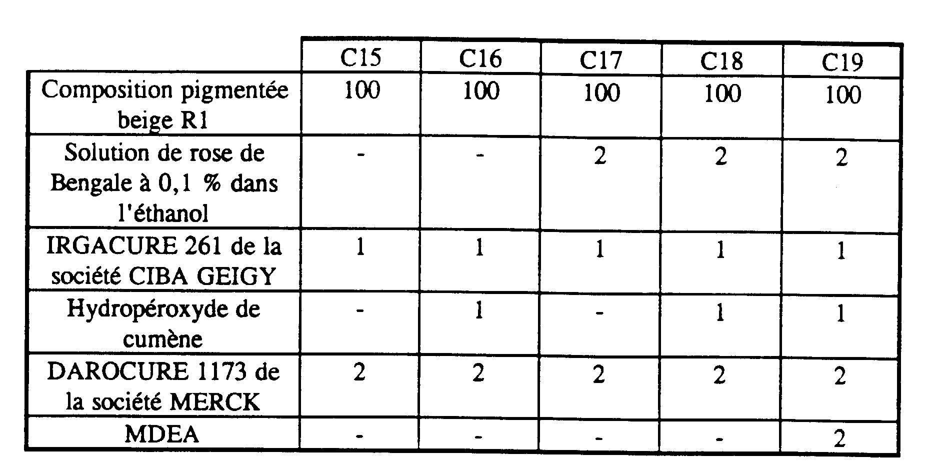

Comme dans les exemples précédents, chacune des compositions est appliquée sous des épaisseurs croissantes que l'on essaye, à chaque fois, de réticuler dans les mêmes conditions que précédemment.
L'épaisseur maximale de revêtement polymérisée est relevée dans le tableau suivant :

| Composition | Epaisseur maximale polymérisée |
|---|---|
| C15 | Quelques µm (<10 µm) (seule la surface est polymérisée) |
| C16 | 60 µm |
| C17 | Quelques µm (<10 µm) (seule la surface est polymérisée) |
| C18 | 120 µm (la teinte initiale est modifiée par la couleur du colorant qui subsiste après irradiation) |
| C19 | 130 µm (la forme colorée du colorant disparaît) |

Ainsi, il apparaît que, contrairement à la composition C9 de l'Exemple 4, la composition C16 décrite ici conduit à une polymérisation de 60 µm d'épaisseur (comme il est décrit dans l'art antérieur, brevet WO 8002879), car les concentrations en substances photosensibles sont plus élevées. Toutefois, cette épaisseur n'opacifie pas le support.
On constate que seul le système photosensible selon l'invention permet de polymériser une épaisseur importante de revêtement pigmenté (120 µm) qui opacifie totalement le support.
Il apparaît également que pour des concentrations plus élevées en organo-métallique et en agent oxydant, comme il est décrit ici, l'apport d'un donneur d'électrons (MDEA) conduit, non seulement à une décoloration du colorant, mais aussi à l'augmentation de l'épaisseur de revêtement polymérisée.

### EXEMPLE 7

Cet exemple a pour but d'illustrer des compositions filmogènes pigmentées de teintes différentes, polymérisant sous irradiation provenant de sources dites "dopées", sous des épaisseurs opacifiantes de 100 µm et contenant le système photosensible selon l'invention.

7.1: On réalise tout d'abord la pâte pigmentaire concentrée bleue P3, par dispersion au défloculeur, puis broyage dans un broyeur à billes de verre, d'un pigment bleu dans un agent dispersant, l'acétobutyrate de cellulose auquel on ajoute un monomère acrylique, l'HDDA.

La composition de cette pâte pigmentaire bleue P3 est, en poids, la suivante :
- Acétobutyrate de cellulose 10
   CAB 552.001 de la société EASTMAN KODAK
- HDDA de la société UCB 40
- Pigment bleu de Prusse 30
   VOSSEN 724 de la société DEGUSSA

Cette pâte pigmentaire bleue P3 est ensuite mélangée au défloculeur à un prépolymère et à un monomère acryliques auxquels on ajoute le système photosensible selon l'invention, pour obtenir la composition filmogène pigmentée bleue réticulable par irradiation, C20, qui est, en poids, la suivante :
- Prépolymère ACTILANE 70 de la société SNPE 50
- HDDA de la société UCB 35
- Pâte pigmentaire bleue P3 15

### Système photosensible selon l'invention :

- Complexe organo-métallique 1,5
   IRGACURE 261 de la société CIBA GEIGY
- Hydropéroxyde de cumène 1
- Solution de rose de Bengale à 0,1 % dans l'éthanol 0,5
- DAROCURE 1173 de la société MERCK 1
- MDEA 3

Cette composition C20 est appliquée sur une plaque de particules de bois mélaminée au moyen d'un applicateur manuel de type "Hand Coater" sous une épaisseur de 100 µm.
Cette plaque est ensuite passée 2 fois sous une lampe à ultra-violets dopée Gallium/Indium de 80 watts/cm à la vitesse de 10 m/mn, puis 1 fois sous une lampe traditionnelle à vapeur de mercure de 80 watts/cm, à la vitesse de 10 m/mn.

On constate que la polymérisation du film est complète, en surface comme à coeur, sous l'épaisseur de 100 µm qui opacifie totalement le support.

7.2 : On réalise de la même façon que dans l'Exemple 7.1 une pâte pigmentaire concentrée rouge P4 dont la composition, en poids, est la suivante :
- Acétobutyrate de cellulose 18
   CAB 552.001 de la société EASTMAN KODAK
- HDDA de la société UCB 72
- Pigment rouge IRGALITHE RBS 10
   de la société CIBA GEIGY

On met ensuite en oeuvre cette pâte pigmentaire rouge P4 comme dans l'Exemple 7.1 pour réaliser une composition filmogène pigmentée réticulable sous irradiation, C21, contenant le système photosensible selon l'invention.
Cette composition C21 est, en poids, la suivante :
- Prépolymère ACTILANE 70 de la société SNPE 50
- HDDA de la société UCB 20
- Pâte pigmentaire rouge P4 30

### Système photosensible selon l'invention :

- Complexe organo-métallique 1,5
   IRGACURE 261 de la société CIBA GEIGY
- Hydropéroxyde de cumène 1
- Solution de jaune d'Acridine à 0,1 % dans l'éthanol 2
- DAROCURE 1173 de la société MERCK 1
- MDEA 3

Cette composition est appliquée sur une plaque de particules de bois mélaminée au moyen d'un applicateur manuel de type "Hand Coater" sous une épaisseur de 100 µm.
Cette plaque est ensuite passée 3 fois sous une lampe à ultra-violets dopée Gallium/Indium de 80 watts/cm à la vitesse de 6 m/mn, puis 1 fois sous une lampe traditionnelle à vapeur de mercure de 80 watts/cm à la vitesse de 10 m/mn.
On constate également que la polymérisation du film est complète, en surface comme à coeur, sous l'épaisseur de 100 µm qui opacifie totalement le support.

### EXEMPLE 8

Cet exemple illustre des compositions filmogènes pigmentées contenant le système photosensible selon l'invention, ayant une teneur en pigments plus faible que celles des exemples précédents, mais polymérisant sous des épaisseurs encore plus importantes.

8.1 : On réalise à partir de la pâte pigmentaire P1 décrite dans l'Exemple 1, une composition filmogène pigmentée beige réticulable par irradiation, C21, qui est, en poids, la suivante :
- Prépolymère ACTILANE 70 de la société SNPE 50
- HDDA de la société UCB 40
- Pâte pigmentaire beige P1 10

### Système photosensible selon l'invention :

- Complexe organo-métallique 1 IRGACURE 261 de la société CIBA GEIGY
- Hydropéroxyde de cumène 1
- Solution de rose de Bengale à 0,1 % dans l'éthanol 2
- DAROCURE 1173 de la société MERCK 2
- MDEA 2

Cette composition C21 est appliquée sur une plaque de particules de bois mélaminée, au moyen d'un applicateur manuel de type "Hand Coater", sous une épaisseur de 200 µm.

Cette plaque est ensuite passée 3 fois sous une lampe à ultra-violets à vapeur de mercure de 80 watts/cm, à une vitesse de 10 m/mn.
On constate que la polymérisation du film est complète en surface comme à coeur sous l'épaisseur de 200 µm.

8.2 : On réalise, à partir de la pâte pigmentaire jaune P2 décrite dans l'Exemple 2, une composition filmogène pigmentée jaune réticulable par irradiation, C22, qui est, en poids, la suivante :
- Prépolymère ACTILANE 70 de la société SNPE 50
- HDDA de la société UCB 40
- Pâte pigmentaire jaune P2 10

### Système photosensible selon l'invention :

- Complexe organo-métallique 0,1
   IRGACURE 261 de la société CIBA GEIGY
- Hydropéroxyde de cumène 0,1
- Solution de rose de Bengale à 0,1 % dans l'éthanol 2
- DAROCURE 1173 de la société MERCK 2
- MDEA 1,5

Cette composition C22 est appliquée sur une plaque de particules de bois mélaminée, au moyen d'un applicateur manuel de type "Hand Coater", sous une épaisseur de 1000 µm, soit mm.

Cette plaque est ensuite passée 3 fois sous une lampe à ultra-violets à vapeur de mercure de 80 watts/cm, à une vitesse de 10 m/mn.
On constate que le polymérisation du film est complète, aussi bien en surface qu'à coeur, même sous l'épaisseur importante de 1000 µm soit 1 mm.

### EXEMPLE 9

A partir de la composition R1 décrite dans l'Exemple 1, on prépare :
* deux compositions réticulables selon l'art connu, C23 et C24, en incorporant dans R1 une combinaison de 2 photoamorceurs qui sont le DAROCURE 1173 et un Titanocène (T) ;
* une composition réticulable, selon l'art connu, C25, en incorporant dans R1 une combinaison
   . d'un colorant qui est le rose de Bengale,
   . d'un agent oxydant qui est l'hydropéroxyde de cumène,
   . d'un photoamorceur qui est le DAROCURE 1173,
   . du Titanocène (T),
   . d'un agent donneur d'électrons qui est la MDEA.

Le Titanocène (T) utilisé est l'IRGACURE 784 disponible auprès de la société CIBA GEIGY et ayant pour formule :

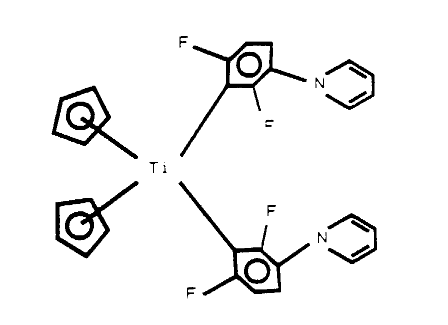

La composition de C23 est, en poids, la suivante :
- Composition pigmentée R1 100

### Système photosensible :

- DAROCURE 1173 de la société MERCK 2
- Titanocène (T) 0,1

La composition de C24 est, en poids, la suivante :
- Composition pigmentée R1 100

### Système photosensible :

- DAROCURE 1173 de la société MERCK 2
- Titanocène (T) 0,2

La composition de C25 est, en poids, la suivante :
- Composition pigmentée R1 100

### Système photosensible :

- Hydropéroxyde de cumène 0,1
- Solution de rose de Bengale à 0,1 % dans l'éthanol 1
- DAROCURE 1173 de la société MERCK 2
- Titanocène (T) 0,1
- MDEA 1

Les compositions C23, C24 et C25, ainsi que les composition C1 et C2 de l'Exemple 1, sont appliquées, comme dans l'Exemple 1, sur des plaques de particules de bois et sous des épaisseurs croissantes, puis irradiées sous une lampe à vapeur de mercure de puissance 80 W/cm avec une vitesse de défilement de 10 m/mn.
On note l'épaisseur maximale de revêtement totalement polymérisé et le nombre de passages sous la lampe qui ont été nécessaires pour que la polymérisation s'effectue.

Les résultats sont regroupés dans le tableau ci-après :

| Composition | C1 selon l'invention | C2 selon l'art connu | | C23 Combinaison de 2 photoamorceurs, selon l'art connu | | C24 Combinaison de 2 photoamorceurs, selon l'art connu | C25 (Combinaison, selon l'art connu, ne comportant pas l'organo-métallique utilisé dans l'invention) |
|---|---|---|---|---|---|---|---|
| Epaisseur maximale polymérisée (en microns) | 120 | 60 | 70 | 80 | 120 | Frisage surface | 80 |
| Nombre de passages sous la lampe à 10 m/mn | 3 | 3 | 10 | 5 | 10 | 2 | 5 |

On constate que seule la composition C1 contenant le système photosensible selon l'invention permet d'obtenir une polymérisation sous une épaisseur importante avec un nombre réduit de passages sous la lampe.

### EXEMPLE 10

Selon le mode opératoire décrit dans l'Exemple 1, on prépare une pâte pigmentaire concentrée blanche P5 et une pâte pigmentaire concentrée rouge P6.
La composition de P5 est, en poids, la suivante :
- Prépolymère uréthanne-acrylate 50
   AM551 de la société AKZO
- Pigment blanc d'oxyde de titane rutile 50
   RL68 de la société THANN & MULHOUSE

La composition de P6 est, en poids, la suivante :
- Prépolymère uréthanne-acrylate 90
   AM551 de la société AKZO
- Pigment rouge IRGALITHE RBS 10
   de la société CIBA GEIGY

En procédant comme dans l'Exemple 1, on prépare ensuite avec P5 et P6 une composition filmogène pigmentée R4 dont la composition en poids est la suivante :
- Prépolymère uréthanne-acrylate 80
   CRAYNOR 931A60
   de la société CRAY VALLEY
- Pâte pigmentaire blanche P5 10
- Pâte pigmentaire rouge P6 10
- Solvant (acétate d'éthyle) 20

En incorporant ensuite dans R4, par mélange au défloculeur, 2 systèmes photosensibles selon l'invention, on réalise 2 compositions réticulables sous irradiation C26 et C27.

La composition de C26 est, en poids, la suivante :
- Composition R4 120

### Système photosensible selon l'invention :

IRGACURE 261 de la société CIBA GEIGY
- Hydroperoxyde de cumène 0,05
- Solution de rose de Bengale à 0,1 % dans l'éthanol 1
- DAROCURE 1173 de la société MERCK 3
- MDEA 0,8.

La composition de C27 est, en poids, la suivante :
- Composition R4 120

### Système photosensible selon l'invention :

- Complexe organo-métallique 0,05
   IRGACURE 261 de la société CIBA GEIGY
- Hydropéroxyde de cumène 0,05
- Solution de rose de Bengale à 0,1 % dans l'éthanol 1
- DAROCURE 1173 de la société MERCK 3
- Titanocène (T) 0,1
- MDEA 0,8
En appliquant ensuite C26 et C27 comme dans l'Exemple 1, on obtient, après un passage sous une lampe dopée au Gallium/Indium de puissance 80 W/cm et 3 passages sous une lampe à vapeur de mercure moyenne pression avec une vitesse de défilement de 10 m/mn, des épaisseurs de film polymérisé de 100 microns.
On constate que la composition C27 apporte un meilleur durcissement à coeur par rapport à la composition C26, ceci ayant pour conséquence d'améliorer l'adhérence du revêtement au support.

### EXEMPLE 11

Dans cet exemple, on a réalisé des compositions filmogènes pigmentées contenant des systèmes photosensibles selon l'invention et ne différant que par la nature de l'agent oxydant mis en oeuvre.
On réalise d'abord, selon le mode opératoire décrit dans l'Exemple 1, une pâte pigmentaire rose P7, dont la composition est, en poids, la suivante :
- Prépolymère SETACURE 551 67,5
   de la société AKZO
- Agent dispersant DYSPERBYK 161 2,5
   de la société BYK CHEMIE
- Pigment blanc oxyde de titane anatase AT1 25
   de la société RHONE-POULENC
- Pigment rouge IRGALITHE 3RS 5
   de la société CIBA-GEIGY

On met ensuite en oeuvre cette pâte pigmentaire P7, comme dans l'Exemple 1, pour réaliser une composition filmogène pigmentée R5 dont la composition est, en poids, la suivante :
- Prépolymère CRAYNOR 931A 0 70
   de la société CRAYNOR
- Acétate d'éthyle 10
- Pâte pigmentaire P7 20

On incorpore ensuite dans R5, 3 systèmes photosensibles selon l'invention ne différant que par la nature de leur agent oxydant, de façon à obtenir 3 compositions filmogènes pigmentées réticulables sous irradiation C28, C29 et C30 dont les compositions sont, en poids, indiquées dans le tableau suivant :

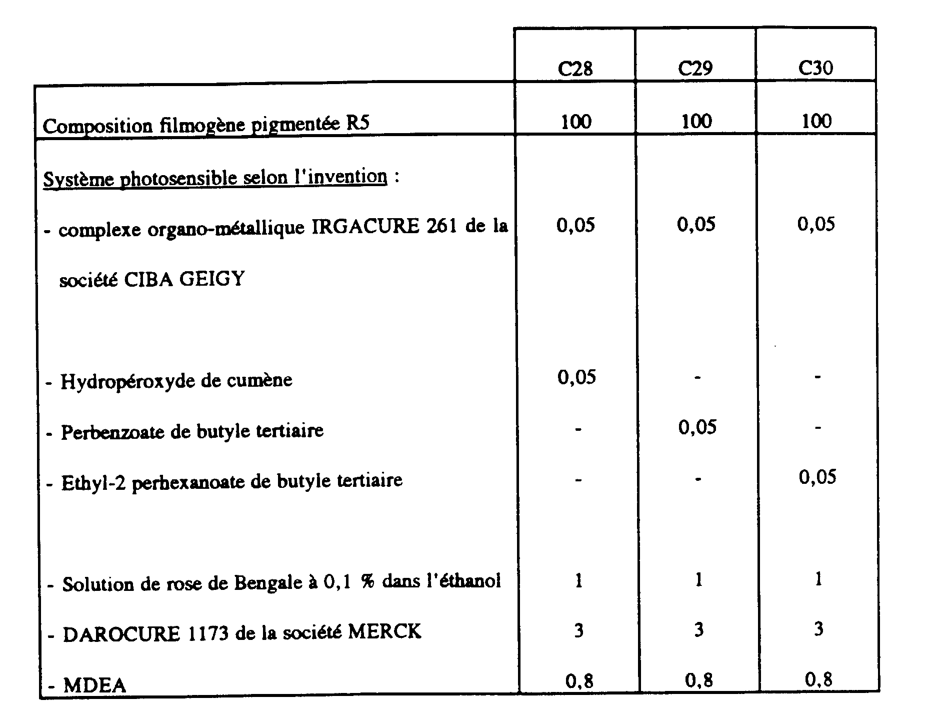

Les compositions C28, C29 et C30 sont appliquées sur une plaque de particules de bois mélaminée, au moyen d'un applicateur manuel de type "Hand Coater", sous une épaisseur de 100 µm.
Cette plaque est ensuite passée une fois sous une lampe à ultra-violets dopée Gallium/Indium, de puissance 80 W/cm à la vitesse de 8 m/mn, puis 3 fois sous une lampe traditionnelle à vapeur de mercure de puissance 80 W/cm à la vitesse de 8 m/mn.
On constate que pour les 3 compositions, la polymérisation du film est complète en surface comme à coeur, sous l'épaisseur de 100 µm.

## Revendications

1. Système photosensible sous irradiation visible et ultra-violette pour des compositions filmogènes pigmentées photoréticulables, caractérisé en ce qu'il comporte :
a) au moins un complexe organo-métallique répondant à la formule :
[R¹(R²M)ₙ] [LQdm]
dans laquelle :
- R¹ est une structure de type π-arène
- R² est une structure de type π-arène ou est l'anion d'un π-arène
- M est le cation d'un métal de valence 1 à 3 des groupes I B, IV B à VII B ou VIII de la classification périodique des éléments,
- L est un métal ou non-métal de valence 2 à 7,
- Q est un halogène
- n est égal à 1 ou 2,
- m est un entier compris entre 3 et 8.
b) au moins un agent sensibilisateur qui est un colorant ayant la propriété d'absorber, au moins pour partie, un domaine de longueur d'onde du spectre d'émission d'une ou plusieurs sources photoniques,
c) au moins un agent oxydant du type composé péroxy,
d) au moins un agent photoamorceur de réaction radicalaire,
e) éventuellement, au moins un agent donneur d'électrons.

2. Système photosensible selon la revendication 1, caractérisé en ce que le colorant est choisi dans le groupe constitué par les colorants nitrosés, nitrés, azos (mono, ou poly azos), azoïques, stilbéniques, les colorants de cétonimine, d'azométhine, de quinoline, de cyanine, de polyméthine, les colorants de triphénylméthane, de diphénylnaphtylméthane, les colorants xanthéniques, les colorants d'acridine, de thiazole, d'indamine, d'indophénol, les colorants aziniques, oxaziniques, thiaziniques, les colorants au soufre, les colorants d'hydroxycétone, les colorants dérivés des quinones et anthraquinones, les colorants indigoïdes et thioindigoïdes, les colorants de phtalocyanine.

3. Système photosensible selon les revendications 1 ou 2, caractérisé en ce que le colorant est préférentiellement choisi parmi ceux de formule : 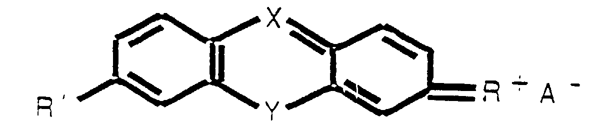 dans laquelle :
- R est chargé positivement et est un groupe imonium, dialkylimonium ou oxonium ,
- R' est un hydrogène ou un groupe amine, alkylamine, dialkylamine ou hydroxyle,
- X est l'azote ou un carbone substitué,
- Y est le soufre, l'oxygène ou l'azote substitué,
- A est un anion.

4. Système photosensible selon l'une quelconque des revendications 1 à 3, caractérisé en ce que le colorant est très préférentiellement choisi dans le groupe constitué par l'éosine Y, le rose de Bengale, l'azure B, la phénosafranine, l'érythrosine B, la phloxine, la riboflavine, la fluoresceïne, la rhodamine B, la safranine O, la pyronine B, le bleu de méthylène, la thionine, le bleu de Capri, l'azure A, le jaune d'acridine, l'orange d'acridine, la résorufine ou la thioflavine T.

5. Système photosensible selon l'une quelconque des revendications 1 à 4, caractérisé en ce que le complexe organo-métallique est préférentiellement choisi dans le groupe constitué par les sels complexes d'un cation η⁶, η⁵ arène fer et d'un anion non-nucléophile, de formule générale : 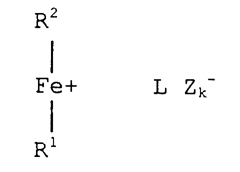 dans laquelle :
- R¹ est un η⁶ arène, un alkylbenzène, un alkoxybenzène, le chlorobenzène, un haloalkylbenzène, le naphtalène, un alkoxynaphtalène, un alkylnaphtalène, un halonaphtalène, un biphényle, l'indène, le pyrène ou de diphénylsulfide,
- R² est l'anion d'un composé cyclopentadiénique,
- L est un métal ou métalloïde de valence 2 à 7,
- Z est un halogène,
- k est égal à la valence de L + 1.

6. Système photosensible selon la revendication 5, caractérisé en ce que préférentiellement le radical R¹ est choisi dans le groupe formé par le benzène, le toluène, le xylène, le mésitylène, le cumène, le chlorobenzène, le parachlorotoluène, le naphtalène, le méthoxynaphtalène, le méthylnaphtalène, le chloronaphtalène, le biphényle, l'indène, le pyrène ou le diphénylsulfide.

7. Système photosensible selon la revendication 5, caractérisé en ce que, préférentiellement, le radical R² est choisi dans le groupe constitué par le cyclopentadiène, l'acétylcyclopentadiène, le benzoylcyclopentadiène, le butylcyclopentadiène, l'amylcyclopentadiène, l'indène.

8. Système photosensible selon la revendication 5, caractérisé en ce que, préférentiellement, l'ion LZₖ⁻ est choisi dans le groupe constitué par SbF₆⁻, BF₄⁻, AsF₆⁻, PF₆⁻.

9. Système photosensible selon l'une quelconque des revendications 5 à 8, caractérisé en ce que le complexe organo-métallique est le :
(η⁵-2,4-Cyclopentadiène-1-yl) [(1,2,3,4,5,6 - η)-(1-methylethyl)benzène] - fer (1+) - hexafluorophosphate(1-).

10. Système photosensible selon l'une quelconque des revendications 1 à 9, caractérisé en ce que l'agent oxydant est choisi dans le groupe constitué par les péroxydes ou les hydropéroxydes organiques, les péresters, ou leurs dérivés.

11. Système photosensible selon l'une quelconque des revendications 1 à 10, caractérisé en ce que l'agent oxydant est choisi dans le groupe constitué par l'hydropéroxyde de tertiobutyle, l'hydropéroxyde de cumène, l'hydropéroxyde de triphénylméthyle, l'hydropéroxyde de tétraline, l'hydropéroxyde de méthyltétraline, et l'hydropéroxyde de décaline, le perbenzoate de butyle tertiaire, l'éthyl-2 perhexanoate de butyle tertiaire.

12. Système photosensible selon l'une quelconque des revendications 1 à 11, caractérisé en ce que l'agent photoamorceur de réaction radicalaire est choisi dans le groupe constitué par les dérivés des cétones aromatiques, les dérivés de l'acétophénone, les dérivés de la benzoïne, les dérivés des benzylcétals, les morpholinocétones, les dérivés sulfoxidiques de cétones aromatiques, les dérivés de type sulfonyl cétones, les oxydes d'acylphosphines, les dérivés de type phénantrènequinone et les titanocènes.

13. Système photosensible selon la revendication 12, caractérisé en ce que l'agent photoamorceur de réaction radicalaire est choisi parmi la benzophénone, l'isopropylthioxanthone, l'hydroxycyclohexylacétophénone, la diméthylhydroxyacétophénone, la 2,2 diméthoxy 1,2 diphényléthane 1-one, la 2-méthyl-1 [4-(méthylthio)phényl] -2-morpholino-propanone-1, l'oxyde de triméthyl-2, 4, 6 benzoyldiphénylphosphine, les titanocènes comportant des cycles aromatiques subsitués par un ou plusieurs halogènes et éventuellement un ou plusieurs autres substituants améliorant leur solubilité.

14. Système photosensible selon l'une quelconque des revendications 1 à 13, caractérisé en ce que l'agent donneur d'électrons est choisi parmi les composés azotés, soufrés ou phosphorés donneurs d'éléctrons.

15. Système photosensible selon la revendication 14, caractérisé en ce que l'agent donneur d'électrons azoté est de formule générale R₃N dans laquelle au moins l'un des trois radicaux R est un radical organique relié à l'atome d'azote, de formule -CH₂R', -CH R'₂ ou CR'₃ où R' est un atome d'hydrogène ou un hydrocarbure ou un hydrocarbure substitué, et les deux autres radicaux R peuvent être l'hydrogène.

16. Système photosensible selon l'une des revendications 14 ou 15, caractérisé en ce que l'agent donneur d'électrons azoté est choisi dans le groupe constitué par les amines secondaires ou tertiaires aliphatiques ou aromatiques.

17. Système photosensible selon la revendication 16, caractérisé en ce que l'agent donneur d'électrons est choisi dans le groupe constitué par la N-phénylglycine, la dibenzylamine, la N-méthyldiéthanolamine, la triéthylamine, la triéthanolamine, la triphénylamine, l'éthyl-4-(diméthylamino)benzoate, la 2-(diméthylamino)éthylbenzoate.

18. Système photosensible selon la revendication 14, caractérisé en ce que l'agent donneur d'électrons soufré est choisi dans le groupe des mercaptans de formule générale RSH où R est un radical alkyl, arylalkyl ou aryl.

19. Système photosensible selon la revendication 14, caractérisé en ce que l'agent donneur d'éléctrons phosphoré est choisi parmi les composés du type triphénylphosphine.

20. Système photosensible selon les revendications 1 à 19, caractérisé en ce que pour 100 parties en poids d'une composition filmogène pigmentée photoréticulable, ses constituants sont introduits à raison :
a) de 0,00001 à 1,0 parties en poids, préférentiellement de 0,0001 à 0,1 parties en poids et très préférentiellement de 0,0001 à 0,01 parties en poids de l'agent sensibilisateur qui est le colorant ;
b) de 0,005 à 5 parties en poids et préférentiellement de 0,05 à 3 parties en poids du complexe organo-métallique ;
c) de 0,005 à 5 parties en poids et préférentiellement de 0,05 à 3 parties en poids de l'agent oxydant du type composé péroxy ;
d) de 0,1 à 8 parties en poids et préférentiellement de 0,5 à 5 parties en poids de l'agent photoamorceur de réaction radicalaire.
e) de 0 à 10 parties en poids et préférentiellement de 0 à 5 parties en poids de l'agent donneur d'électrons.

21. Compositions filmogènes pigmentées photoréticulables constituées d'au moins un polymère et/ou prépolymère à fonctions éthyléniques libres, au moins un monomère à fonctions éthyléniques libres, éventuellement au moins un solvant organique, au moins un pigment pulvérulent insoluble, tinctoriel ou non, éventuellement au moins une matière de charge pulvérulente et éventuellement au moins un additif classiquement utilisé par l'homme de l'art dans les compositions de revêtements, caractérisées en ce que on y incorpore le système photosensible selon les revendications 1 à 20.

22. Compositions filmogènes selon la revendication 21, caractérisées en ce que le polymère et/ou prépolymère à fonctions éthyléniques libres est choisi dans le groupe constitué par ceux du type :
- époxy-acrylates, époxy-méthacrylates,
- uréthanne-acrylates, uréthanne-méthacrylates,
- aromatiques et/ou aliphatiques,
- polyesters-acrylates, polyesters-méthacrylates,
- polyesters insaturés,
- vinyl-acryliques,
- polyènes-thiols.

23. Compositions filmogènes selon l'une quelconque des revendications 21 ou 22, caractérisées en ce que le monomère à fonctions éthylèniques libres est choisi dans le groupe des monomères vinyliques et/ou acryliques et/ou méthacryliques mono et/ou polyfonctionnels.

24. Application du système photosensible selon l'une quelconque des revendications 1 à 20, introduit dans les compositions filmogènes pigmentées photoréticulables selon l'une quelconque des revendications 21 à 23, aux domaines de la décoration et/ou de la protection de supports, plus particulièrement en bois, en dérivés du bois, en matériaux plastiques, en métal, en matériaux composites d'origine minérale ou organique, naturels ou de synthèse.

## Patentansprüche

1. Unter VIS- und UV-Bestrahlung lichtempfindliches System für filmbildende pigmenthaltige photovernetzbare Zusammensetzungen, dadurch gekennzeichnet, daß es enthält:
a) mindestens einen metallorganischen Komplex entsprechend der Formel:
[R¹(R²M)ₙ][LQₘ]
worin:
- R¹ eine Struktur vom Typ π-Aren ist,
- R² eine Struktur vom Typ π-Aren oder ein Anion eines π-Arens ist,
- M das Kation eines Metalls mit der Wertigkeit 1 bis 3 aus den Gruppen IB, IVB bis VIIB oder VIII des Periodensystems der Elemente ist,
- L ein Metall oder Nichtmetall mit der Wertigkeit 2 bis 7 ist,
- Q ein Halogen ist,
- n gleich 1 oder 2 ist,
- m eine ganze Zahl zwischen 3 und 8 ist,
b) mindestens einen Sensibilisator, der ein Farbstoff ist, welcher die Eigenschaft hat, mindestens zum Teil einen Wellenlängenbereich des Emissionsspektrums einer oder mehrerer Photonenquellen zu absorbieren,
c) mindestens ein Oxidationsmittel vom Typ der Peroxyverbindung,
d) mindestens einen Photoinitiator für radikalische Reaktion,
e) gegebenenfalls mindestens einen Elektronendonator.

2. Lichtempfindliches System nach Anspruch 1, dadurch gekennzeichnet, daß der Farbstoff in der Gruppe gewählt wird, die aus den Nitroso-, Nitro-, Azo- (Mono- oder Polyazo-), Stilben-Farbstoffen, den Ketonimin-, Azomethin-, Chinolin-, Cyanin-, Polymethin-Farbstoffen, den Triphenylmethan-, Diphenylnaphtylmethan-Farbstoffen, den Xanthenfarbstoffen, den Acridin-, Thiazol-, Indamin-, Indophenol-Farbstoffen, den Azin-, Oxazin-, Thiazinfarbstoffen, den Schwefelfarbstoffen, den Hydroxyketonfarbstoffen, den von den Chinonen und Anthrachinonen abgeleiteten Farbstoffen, den indigoiden und thioindigoiden Farbstoffen, den Phtalocyaninfarbstoffen besteht.

3. Lichtempfindliches System nach den Ansprüchen 1 oder 2, dadurch gekennzeichnet, daß der Farbstoff bevorzugt gewählt wird unter denen der Formel: 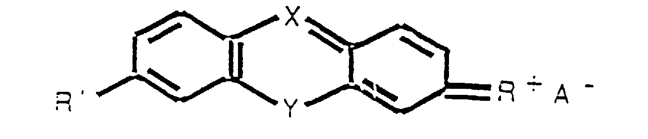 worin:
- R positiv geladen ist und eine Imonium-, Dialkylimonium- oder Oxoniumgruppe ist,
- R' ein Wasserstoff oder eine Amin-, Alkylamin-, Dialkylamin- oder Hydroxylgruppe ist,
- X Stickstoff oder ein substituierter Kohlenstoff ist,
- Y Schwefel, Sauerstoff oder substituierter Stickstoff ist,
- A ein Anion ist.

4. Lichtempfindliches System nach einem der Ansprüche 1 bis 3, dadurch gekennzeichnet, daß der Farbstoff besonders bevorzugt in der Gruppe gewählt wird, die aus Eosin Y, Bengalrosa, Azur B, Phenosafranin, Erythrosin B, Phloxin, Riboflavin, Fluorescein, Rhodamin B, Safranin O, Pyronin B, Methylenblau, Thionin, Capriblau, Azur A, Acridingelb, Acridinorange, Resorufin oder Thioflavin T besteht.

5. Lichtempfindliches System nach einem der Ansprüche 1 bis 4, dadurch gekennzeichnet, daß der metallorganische Komplex bevorzugt in der Gruppe gewählt wird, die aus den Komplexsalzen eines η⁶, η⁵-Aren-Eisen-Kations und eines nicht nucleophilen Anions mit der allgemeinen Formel: 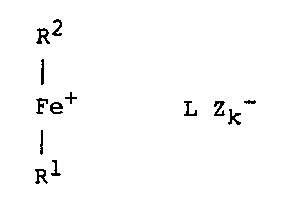 besteht, worin:
- R¹ ein η⁶-Aren, ein Alkylbenzol, ein Alkoxybenzol, Chlorbenzol, ein Halogenalkylbenzol, Naphtalin, ein Alkoxynaphtalin, ein Alkylnaphtalin, ein Halogennaphtalin, ein Biphenyl, Inden, Pyren oder Diphenylsulfid ist,
- R² das Anion einer Cyclopentadienverbindung ist,
- L ein Metall oder Nichtmetall mit der Wertigkeit 2 bis 7 ist,
- Z ein Halogen ist,
- k gleich der Wertigkeit von L vermehrt um 1 ist.

6. Lichtempfindliches System nach Anspruch 5, dadurch gekennzeichnet, daß der Rest R¹ bevorzugt in der Gruppe gewählt wird, die aus Benzol, Toluol, Xylol, Mesitylen, Cumol, Chlorbenzol, Parachlortoluol, Naphtalin, Methoxynaphtalin, Methylnaphtalin, Chlornaphtalin, Biphenyl, Inden, Pyren oder Diphenylsulfid besteht.

7. Lichtempfindliches System nach Anspruch 5, dadurch gekennzeichnet, daß der Rest R² bevorzugt in der Gruppe gewählt wird, die aus Cyclopentadien, Acetylcyclopentadien, Benzoylcyclopentadien, Butylcyclopentadien, Amylcyclopentadien, Inden besteht.

8. Lichtempfindliches System nach Anspruch 5, dadurch gekennzeichnet, daß das Ion LZₖ⁻ in der Gruppe gewählt wird, die aus SbF₆⁻, BF₄⁻, ASF₆⁻, PF₆⁻ besteht.

9. Lichtempfindliches System nach einem der Ansprüche 5 bis 8, dadurch gekennzeichnet, daß der metallorganische Komplex das:
(η⁵-2,4-Cyclopentadien-1-yl)[(1,2,3,4,5,6-η)-(1-methylethyl)benzol]-eisen(1+)-hexafluorophosphat(1-) ist.

10. Lichtempfindliches System nach einem der Ansprüche 1 bis 9, dadurch gekennzeichnet, daß das Oxidationsmittel in der Gruppe gewählt wird, die aus den organischen Peroxiden oder Hydroperoxiden, den Perestern oder ihren Derivaten besteht.

11. Lichtempfindliches System nach einem der Ansprüche 1 bis 10, dadurch gekennzeichnet, daß das Oxidationsmittel in der Gruppe gewählt wird, die aus tert-Butyl-hydroperoxid, Cumol-hydroperoxid, Triphenylmethyl-hydroperoxid, Tetralin-hydroperoxid, Methyltetralin-hydroperoxid und Decalin-hydroperoxid, tert-Butyl-perbenzoat, 2-Ethylperhexansäure-tert-butylester besteht.

12. Lichtempfindliches System nach einem der Ansprüche 1 bis 11, dadurch gekennzeichnet, daß der Photoinitiator für radikalische Reaktion in der Gruppe gewählt wird, die aus den Derivaten der aromatischen Ketone, den Acetophenonderivaten, den Benzoinderivaten, den Derivaten der Benzylketale, den Morpholinoketonen, den Sulfoxid-Derivaten aromatischer Ketone, den Derivaten vom Typ der Sulfonylketone, den Acylphosphinoxiden, den Derivaten vom Typ Phenanthrenchinon und den Titanocenen besteht.

13. Lichtempfindliches System nach Anspruch 12, dadurch gekennzeichnet, daß der Photoinitiator für radikalische Reaktion gewählt wird unter Benzophenon, Isopropylthioxanthon, Hydroxycyclohexylacetophenon, Dimethylhydroxyacetophenon, 2,2-Dimethoxy-1,2-diphenylethan-1-on, 2-Methyl-1-[4-(methylthio)-phenyl]-2-morpholino-propanon-1, 2,4,6-Trimethylbenzoyldiphenylphosphinoxid, den Titanocenen, die aromatische Ringe enthalten, welche mit einem oder mehreren Halogenen und gegebenfalls mit einem oder mehreren weiteren ihre Löslichkeit verbessernden Substituenten substituiert sind.

14. Lichtempfindliches System nach einem der Ansprüche 1 bis 13, dadurch gekennzeichnet, daß der Elektronendonator unter den stickstoffhaltigen, schwefelhaltigen oder phosphorhaltigen Elektronendonatoren gewählt wird.

15. Lichtempfindliches System nach Anspruch 14, dadurch gekennzeichnet, daß der stickstoffhaltige Elektronendonator die allgemeine Formel R₃N hat, worin mindestens einer der drei Reste R ein an das Stickstoffatom gebundener organischer Rest der Formel -CH₂R', -CHR'₂ oder CR'₃ ist, wo R' ein Wasserstoffatom oder ein Kohlenwasserstoff oder ein substituierter Kohlenwasserstoff ist, und die beiden anderen Reste R Wasserstoff sein können.

16. Lichtempfindliches System nach einem der Ansprüche 14 oder 15, dadurch gekennzeichnet, daß der Elektronendonator in der Gruppe gewählt wird, die aus den sekundären oder tertiären aliphatischen oder aromatischen Aminen besteht.

17. Lichtempfindliches System nach Anspruch 16, dadurch gekennzeichnet, daß der Elektronendonator in der Gruppe gewählt wird, die aus N-Phenylglycin, Dibenzylamin, N-Methyldiethanolamin, Triethylamin, Triethanolamin, Triphenylamin, Ethyl-4-(dimethylamino)benzoat, Ethyl-2-(dimethylamino)benzoat besteht.

18. Lichtempfindliches System nach Anspruch 14, dadurch gekennzeichnet, daß der schwefelhaltige Elektronendonator in der Gruppe der Mercaptane mit der allgemeinen Formel RSH gewählt wird, worin R ein Alkyl-, Arylalkyl- oder Arylrest ist.

19. Lichtempfindliches System nach Anspruch 14, dadurch gekennzeichnet, daß der phosphorhaltige Elektronendonator unter den Verbindungen vom Typ Triphenylphosphin gewählt wird.

20. Lichtempfindliches System nach den Ansprüchen 1 bis 19, dadurch gekennzeichnet, daß auf 100 Gewichtsteile einer filmbildenden pigmenthaltigen photovernetzbaren Zusammensetzung seine Bestandteile eingesetzt werden im Anteil:
a) von 0,00001 bis 1,0 Gewichtsteilen, bevorzugt von 0,0001 bis 0,1 Gewichtsteilen und besonders bevorzugt von 0,0001 bis 0,01 Gewichtsteilen des Sensibilisators, welcher der Farbstoff ist;
b) von 0,005 bis 5 Gewichtsteilen und bevorzugt von 0,05 bis 3 Gewichtsteilen des metallorganischen Komplexes;
c) von 0,005 bis 5 Gewichtsteilen und bevorzugt von 0,05 bis 3 Gewichtsteilen des Oxidationsmittels vom Typ der Peroxyverbindung;
d) von 0,1 bis 8 Gewichtsteilen und bevorzugt von 0,5 bis 5 Gewichtsteilen des Photoinitiators für radikalische Reaktion;
d) von 0 bis 10 Gewichtsteilen und bevorzugt von 0 bis 5 Gewichtsteilen des Elektronendonators.

21. Filmbildende pigmenthaltige photovernetzbare Zusammensetzungen, bestehend aus mindestens einem Polymer und/oder Präpolymer mit freien Ethylenfunktionen, mindestens einem Monomer mit freien Ethylenfunktionen, gegebenenfalls mindestens einem organischen Lösungsmittel, mindestens einem unlöslichen pulverförmigen färbenden oder nicht färbenden Pigment, gegebenenfalls mindestens einem pulverförmigen Füllstoff und gegebenenfalls mindestens einem Zusatzstoff, der üblicherweise vom Fachmann in den Zusammensetzungen für Beschichtungen verwendet wird, dadurch gekennzeichnet, daß man hierhinein das lichtempfindliche System nach den Ansprüchen 1 bis 20 einbaut.

22. Filmbildende Zusammensetzungen nach Anspruch 21, dadurch gekennzeichnet, daß das Polymer und/oder Präpolymer mit freien Ethylenfunktionen in der Gruppe gewählt wird, die aus denjenigen des Typs:
- Epoxy-Acrylate, Epoxy-Methacrylate,
- Urethan-Acrylate, Urethan-Methacrylate,
- Aromaten und/oder Aliphaten,
- Polyester-Acrylate, Polyester-Methacrylate,
- ungesättigte. Polyester,
- Vinyl-Acrylverbindungen,
- Polyene-Thiole.
besteht.

23. Filmbildende Zusammensetzungen nach einem der Ansprüche 21 oder 22, dadurch gekennzeichnet, daß das Monomer mit freien Ethylenfunktionen in der Gruppe der mono- und/oder polyfunktionellen Vinyl- und/oder Acryl- und/oder Methacrylmonomere gewählt wird.

24. Anwendung des lichtempfindlichen Systems nach einem der Ansprüche 1 bis 20, den filmbildenden pigmenthaltigen photovernetzbaren Zusammensetzungen nach einem der Ansprüche 21 bis 23 zugesetzt, auf den Gebieten der Dekoration und/oder des Schutzes von Unterlagen, insbesondere aus Holz, aus Holzderivaten, aus Plastikmaterialien, aus Metall, aus natürlichen oder synthetischen Verbundmaterialien mineralischen oder organischen Ursprungs.

## Claims

1. Visible and ultraviolet irradiation photosensitive system for film-forming pigmented photocrosslinkable compositions characterized in that it comprises:
a) at least one organometallic complex conforming to the formula:
[R¹(R²M)ₙ] [LQm]
in which:
- R¹ is a π-arene type structure
- R² is a π-arene type structure or is the anion of a π-arene.
- M is the cation of a metal of valence 1 to 3 of groups IB, IVB to VIIB or VIII of the periodic table of the elements
- L is a metal or nonmetal of valence 2 to 7,
- Q is a halogen
- n is equal to 1 or 2,
- m is a whole number comprised between 3 and 8.
b) at least one sensitizer agent which is a coloring agent having the property of absorbing, at least partially, a wavelength range of the emission spectrum of one or several photon sources,
c) at least one oxidizing agent of the peroxy compound type,
d) at least one photoinitiator agent of radical reaction,
e) possibly, at least one electron donor agent.

2. Photosensitive system according to Claim 1, characterized in that the coloring agent is chosen from the group made up by nitrosated, nitrated, azos (mono or poly azo), azoic, stilbenic coloring agents, ketoninine, azomethine, quinoline, cyanine, polymethine coloring agents, triphenylmethane, diphenylnaphthylmethane coloring agents, xanthenic coloring agents, acridine, thiazole, indamine, indophenol coloring agents, azinic, oxazinic, thiazinic coloring agents, sulfur coloring agents, hydroxyketone coloring agents, quinone and anthraquinone derivative coloring agents, indigoid and thioindigoid coloring agents, phthalocyanine coloring agents.

3. Photosensitive system according to Claims 1 or 2, characterized in that the coloring agent is preferentially chosen among those of formula: 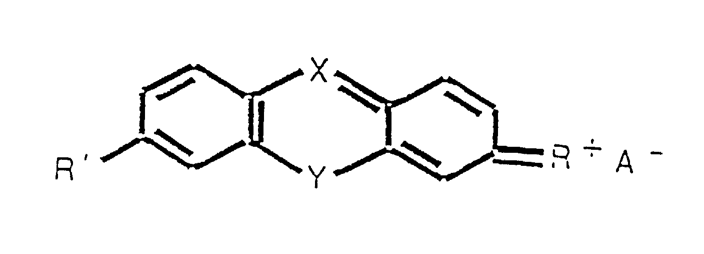 in which:
- R is positively charged and is an imonium, dialkylimonium or oxonium group;
- R' is a hydrogen or an amine, alkylamine, dialkylamine or hydroxyl group,
- X is nitrogen or a substituted carbon,
- Y is sulfur, oxygen or substituted nitrogen,
- A is an anion.

4. Photosensitive system according to any one of Clains 1 to 3, characterized in that the coloring agent is very preferentially chosen from the group made up of eosin Y, Bengal rose, azure B, phenosafranine, erythrosine B, phloxine, riboflavin, fluoroscein, rhodamine B, safranine 0, pyronin B, methylene blue, thionin, Capri blue, azure A, acridine yellow, acridine orange, resorufin or thioflavine T.

5. Photosensitive system according to any one of Claims 1 to 4, characterized in that the organometallic complex is preferentially chosen from the group made up by the complex salts of a cation η⁶, η⁵ arene iron and a of non-nucleophilic anion, of general formula: 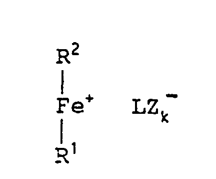 in which:
- R¹ is a η⁶ arene, an alkylbenzene, an alkoxybenzene, a chlorobenzene, a haloalkylbenzene, naphthalene, an alkoxynaphthalene, an alkylnaphthalene, a halonaphthalene, a biphenyl, indene, pyrene, or diphenylsulfide,
- R² is the anion of a cyclopentadiene compound,
- L is a metal or metalloid of valence 2 to 7,
- Z is a halogen,
- k is equal to the valence of L + 1.

6. Photosensitive system according to Claim 5, characterized in that preferentially the R¹ radical is chosen from the group formed by benzene, toluene, xylene, mesitylene, cumene, chlorobenzene, parachlorotoluene, naphthalene, methoxynaphthalene, methylnaphthalene, chloronaphthalene, biphenyl, indene, pyrene or diphenylsulfide.

7. Photosensitive system according to Claim 5, characterized in that, preferentially, the radical R² is chosen from the group made up of cyclopentadiene, acetylcyclopentadiene, benzoylcyclopentadiene, butylcyclopentadiene, amylcyclopentadiene, indene.

8. Photosensitive system according to Claim 5, characterized in that, preferentially, the LZₖ⁻ ion is selected from the group comprised of SbF₆⁻, BF₄⁻, AsF₆⁻, PF₆⁻.

9. Photosensitive system according to any one of Claims 5 to 8, characterized in that the organometallic complex is:
(η⁵-2,4-cyclopentadiene-1-yl) [(1,2,3,4,5,6-η)-(1-methylethyl)benzene]-iron (1+)-hexafluorophosphate (1-)

10. Photosensitive system according to any one of Claims 1 to 9, characterized in that the oxidizing agent is chosen from the group made up of organic peroxides or hydroperoxides, peresters, or their derivatives.

11. Photosensitive system according to any one of Claims 1 to 10, characterized in that the oxidizing agent is chosen from the group made up of tert-butyl hydroperoxide, cumene hydroperoxide, triphenylmethyl hydroperoxide, tetralin hydroperoxide, methyltetralin hydroperoxide and decalin hydroperoxide, tertiary butyl peroxybenzoate, tertiary butyl peroxy-2-ethyl hexanoate.

12. Photosensitive system according to any one of Claims 1 to 11, characterized in that the photoinitiator agent of radical reaction is chosen from the group made up of the derivatives of aromatic ketones, acetophenone derivatives, benzoin derivatives, benzylketal derivatives, morpholinoketones, sulfoxide derivatives of aromatic ketones, the sulfonyl ketone type derivatives, acylphosphine oxides, derivatives of the phenanthrenequinone type and titanocenes.

13. Photosensitive system according to Claim 12, characterized in that the photoinitiator agent of radical reaction is chosen among benzophenone, isopropylthioxanthone, hydroxycyclohexylacetophenone, dimethylhydroxyacetophenone, 2,2-dimethoxy 1,2-diphenylethane 1-one, 2-methyl-1 (4-(methylthio)phenyl]-2-morpholino-propanone-1,2,4,6-trimethylbenzoyldiphenylphosphine oxide, titanocenes having aromatic rings substituted by one or more halogens and possibly one or more other substituents improving their solubility.

14. Photosensitive system according to any one of Claims 1 to 13, characterized in that the electron donor aaent is chosen among nitrogenated, sulfurated or phosphorated electron donor compounds.

15. Photosensitive system according to Claim 14, characterized in that the nitrogenated electron donor agent has the general formula R₃N in which at least one of the three R radicals is an organic radical bound to the nitrogen atom, of the formula -CH₂ R', -CH R'₂ or CR'₃ where R' is a hydrogen atom or a hydrocarbon or a substituted hydrocarbon, and the two other R radicals can be hydrogen.

16. Photosensitive system according to Claims 14 or 15, characterized in that the nitrogenated electron donor agent is chosen from the group made up of secondary or tertiary aliphatic or aromatic amines.

17. Photosensitive system according to Claim 16, characterized in that the electron donor agent is chosen from the group made up of N-phenylglycine, dibenzylamine, N-methyldiethanolamine, triethylamine, triethanolamine, triphenylamine, ethyl-4-(dimethylamino)benzoate, 2-(dimethylamino)ethylbenzoate.

18. Photosensitive system according to Claim 14, characterized in that the sulfurated electron donor agent is chosen from the group of mercaptans of general formula RSH where R is an alkyl, arylalkyl or aryl radical.

19. Photosensitive system according to Claim 14, characterized in that the phosphorated electron donor agent is chosen among compounds of the triphenylphosphine type.

20. Photosensitive system according to Claims 1 to 19, characterized in that for 100 parts by weight of a film-forming pigmented photocrosslinkable composition, its constituents are introduced in amounts of:
a) 0.00001 to 1.0 part by weight, preferentially 0.0001 to 0.1 part by weight and very preferentially 0.0001 to 0.01 part by weight of the sensitizing agent which is the coloring agent;
b) 0.005 to 5 parts by weight and preferentially 0.05 to 3 parts by weight of the organometallic complex;
c) 0.005 to 5 parts by weight and preferentially 0.05 to 3 parts by weight of the oxidizing agent of the peroxy compound type;
d) 0.1 to 8 parts by weight and preferentially 0.5 to 5 parts by weight of the photoinitiator agent of radical reaction.
e) 0 to 10 parts by weight and preferentially 0 to 5 parts by weight of the electron donor agent.

21. Film-forming pigmented photocrosslinkable compositions made up of at least one polymer and/or prepolymer with free ethylene functions, at least one monomer with free ethylene functions, possibly at least one organic solvent, at least one insoluble powdered pigment, tinctorial or not, possibly at least one powdered filler material, and possibly at least one additive classically used by the expert in coating compositions, characterized in that the photosensitive system according to Claims 1 to 20 is incorporated therein.

22. Film-forming compositions according to Claim 21, characterized in that the polymer and/or prepolymer with free ethylene functions is chosen from the group made up of those of the type:
- epoxyacrylates, epoxymethacrylates,
- urethaneacrylates, urethanemethacrylates,
- aromatics and/or aliphatics,
- polyesteracrylates, polyestermethacrylates,
- unsaturated polyesters,
- vinyl acrylics,
- polyenethiols.

23. Film-forming compositions according to any one of Claims 21 or 22, characterized in that the monomer with free ethylene functions is chosen from the group of mono and/or polyfunctional vinyl and/or acrylic and/or methacrylic monomers.

24. Application of the photosensitive system according to any one of Claims 1 to 20, introduced into film-forming pigmented photocrosslinkable compositions according to any one of Claims 21 to 23, in the fields of decoration and/or protection of supports, more particularly of wood, wood derivatives, plastics, metal, composite materials of mineral or organic origin, natural or synthetic.
